# EUROPEAN PATENT APPLICATION

(11) **EP 4 742 545 A1**
(43) Date of publication of application: **13.05.2026**
(21) Application number: 24891876.5
(22) Date of filing: 14.11.2024
(51) Int. Cl.: H04B 1/00, H04B 1/50, H04W 76/16, H03F 1/02, H04W 76/15, H04L 5/00, H04W 88/06, H04B 1/04

(54) **ELECTRONIC DEVICE COMPRISING COMMUNICATION CIRCUIT**

(30) Priority: 15.11.2023 KR 20230158523; 29.01.2024 KR 20240013095
(71) Applicant: Samsung Electronics Co., Ltd., Suwon-si, Gyeonggi-do 16677 (KR)
(72) Inventor: CHOI, Youngbaek, Suwon-si, Gyeonggi-do 16677 (KR); JO, Jihoon, Suwon-si, Gyeonggi-do 16677 (KR); MOON, Yohan, Suwon-si, Gyeonggi-do 16677 (KR); YOO, Jonghun, Suwon-si, Gyeonggi-do 16677 (KR)
(74) Representative: Gulde & Partner
(86) International application number: PCT/KR2024/096561
(87) International publication number: WO 2025/105930

(57) **Abstract**

An electronic device of the disclosure may include: a radio frequency integrated circuit (RFIC) configured to output multiple radio frequency signals of a first communication network or a second communication network; power supply circuitry including first power source circuitry and second power source circuitry; multiple power amplifiers including a first power amplifier configured to amplify a radio frequency signal of a first port of the RFIC and cause a transmission signal to be output via a first antenna, a second power amplifier connected to a second antenna and configured to amplify a radio frequency signal of a second port of the RFIC and cause a transmission signal to be output via the second antenna, a third power amplifier configured to amplify a radio frequency signal of a third port of the RFIC and cause a transmission signal to be output via a third antenna, and a fourth power amplifier configured to amplify a radio frequency signal of a fourth port of the RFIC or a radio frequency signal of a fifth port of the RFIC and cause a transmission signal to be output via a fourth antenna; radio frequency front end (RFFE) circuitry including switches configured to connect the multiple power amplifiers and the power supply circuitry; a memory storing instructions; at least one processor comprising processing circuitry; a first switch configured to cause the radio frequency signal of the fourth port or that of the fifth port to be transferred to the fourth power amplifier under control of at least one processor; and a second switch connected to the first power source circuitry or the second power source circuitry and configured to supply power to the fourth power amplifier and the third power amplifier under control of at least one processor, wherein at least one processor, individually and/or collectively, is configured to cause the electronic device to: based on the fourth power amplifier receiving power from the first power source circuitry via the second switch, control the first switch so that the transmission signal output from the fourth port is output via the fourth power amplifier; and based on the fourth power amplifier receiving power from the second power source circuitry via the second switch, control the first switch so that the transmission signal output from the fifth port is output via the fourth power amplifier.

## Description

### [Technical Field]

The disclosure relates to an electronic device including a communication circuitry.

### [Background Art]

For mobile communication services, an E-UTRAN new radio-dual connectivity (EN-DC) (or dual connectivity) technology for simultaneously connecting two or more communication signals (e.g., LTE network/4G network and 5G network) is applied. In addition, for mobile communication services, a transmission hopping (TX hopping) technology capable of selecting and changing a transmission antenna is applied in order to increase the output efficiency of an electronic device that simultaneously outputs multiple transmission signals.

An RF communication structure capable of simultaneously transmitting at least two or more communication signals is applied to an electronic device in order to support the new radio carrier aggregation (NR CA) function, an EN-DC function, and/or a TX hopping function.

The above-described information may be provided as related art for the purpose of assisting in understanding the disclosure. No assertion is made as to whether any of the above might be applicable as prior art with regard to the disclosure.

### [Disclosure of Invention]

### [Technical Problem]

For mobile communication services, there is an increasing demand for supporting new radio frequency (RF) bands and various communication technologies, such as an NR CA function, an EN-DC function, and/or a TX hopping function. To this end, electronic devices have difficulty of adding, to an insufficient mounting space, power amplifiers and power source circuitries for transmission of multiple communication signals.

An electronic device including a communication circuitry of the disclosure is to support various communication technologies, such as an NR CA function, an EN-DC function, and/or a TX hopping function.

Embodiments of the disclosure provide an electronic device including a radio frequency integrated circuit (RFIC) configured to output multiple radio frequency signals of a first communication network or a second communication network, and a power supply circuitry including a first power source circuitry and a second power source circuitry.

According to an example embodiment, an electronic device of the disclosure may include: multiple power amplifiers including a first power amplifier configured to amplify a radio frequency signal of a first port of a radio frequency integrated circuit (RFIC) and cause a transmission signal to be output via a first antenna, a second power amplifier connected to a second antenna and configured to amplify a radio frequency signal of a second port of the RFIC and cause a transmission signal to be output via the second antenna, a third power amplifier configured to amplify a radio frequency signal of a third port of the RFIC and cause a transmission signal to be output via a third antenna, and a fourth power amplifier configured to amplify a radio frequency signal of a fourth port of the RFIC or a fifth port of the RFIC and cause a transmission signal to be output via a fourth antenna.

The electronic device of the disclosure may include radio frequency front end (RFFE) circuitry including switches configured to connect the multiple power amplifiers and the power supply circuitry.

The electronic device of the disclosure may include a memory configured to store instructions, and at least one processor comprising processing circuitry.

The electronic device of the disclosure may include: a first switch configured to cause the radio frequency signal of the fourth port or the radio frequency signal of the fifth port to be transferred to the fourth power amplifier under the control of at least one processor; and a second switch connected to the first power source circuitry or the second power source circuitry and configured to supply power to the fourth power amplifier and the third power amplifier under the control of at least one processor.

The instructions may, when executed by at least one processor, individually and/or collectively, cause the electronic device to: based on the fourth power amplifier receiving power from the first power source circuitry via the second switch, control the first switch so that the transmission signal output from the fourth port is output via the fourth power amplifier; and based on the fourth power amplifier receiving power from the second power source circuitry via the second switch, control the first switch so that the transmission signal output from the fifth port is output via the fourth power amplifier.

An electronic device including a communication circuitry of the disclosure can reduce power amplifiers or power source circuitries added to the communication circuitry while supporting transmission of various transmission signals, thereby securing a mounting space of the electronic device.

### [Brief Description of Drawings]

With regard to the description of the drawings, the same or like reference signs may be used to designate the same or like elements. Further, the above and other aspects, features and advantages of certain embodiment of the present disclosure will be more apparent from the following detailed description, taken in conjunction with the accompanying drawings, in which:
FIG. 1 is a block diagram illustrating an example electronic device in a network environment according to various embodiments;
FIG. 2 is a block diagram illustrating an example configuration of the electronic device for supporting legacy network communication and 5G network communication according to various embodiments;
FIG. 3 is a block diagram illustrating an example configuration of the electronic device according to various embodiments;
FIG. 4 is a diagram illustrating an example electronic device according to various embodiments;
FIG. 5 is a diagram illustrating an example electronic device according to various embodiments;
FIG. 6 is a diagram illustrating an example electronic device according to various embodiments;
FIG. 7 is a flowchart illustrating an example communication circuitry control operation of the electronic device according to various embodiments; and
FIG. 8 is a flowchart illustrating an example communication circuitry control operation of the electronic device according to various embodiments.

### [Mode for the Invention]

Hereinafter, various example embodiments of the disclosure will be described in greater detail with reference to the drawings. However, the disclosure may be implemented in various forms and is not limited to embodiments set forth herein. With regard to the description of the drawings, the same or like reference signs may be used to designate the same or like elements. Also, in the drawings and the relevant descriptions, description of well-known functions and configurations may be omitted for the sake of clarity and brevity.

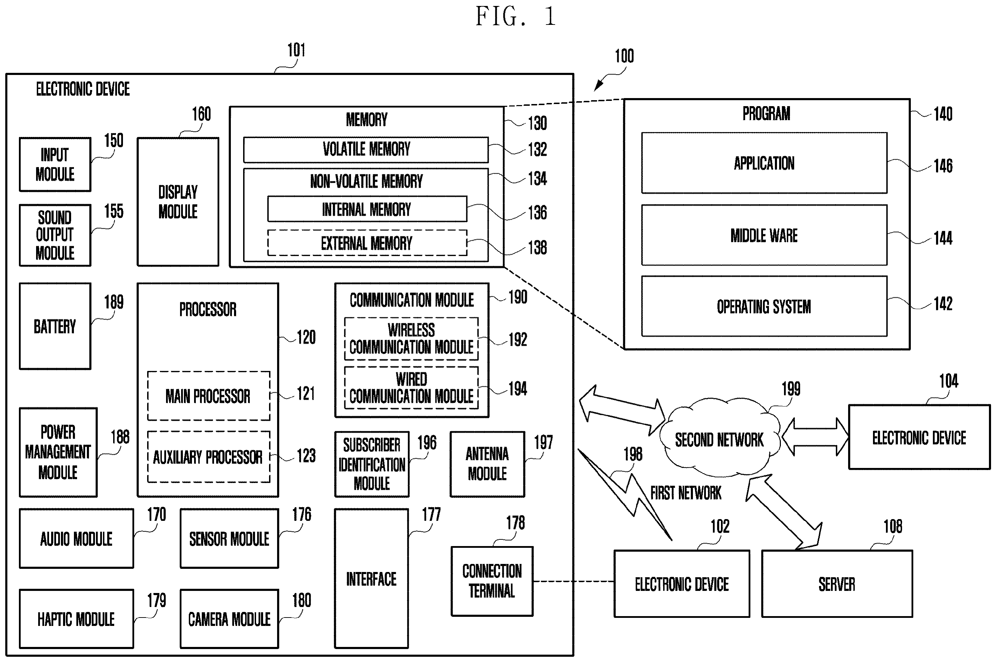

FIG. 1 is a block diagram illustrating an example electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In various embodiments, at least one of the components (e.g., the connecting terminal 178) may be omitted from the electronic device 101, or one or more other components may be added in the electronic device 101. In various embodiments, some of the components (e.g., the sensor module 176, the camera module 180, or the antenna module 197) may be implemented as a single component (e.g., the display module 160).

The processor 120 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

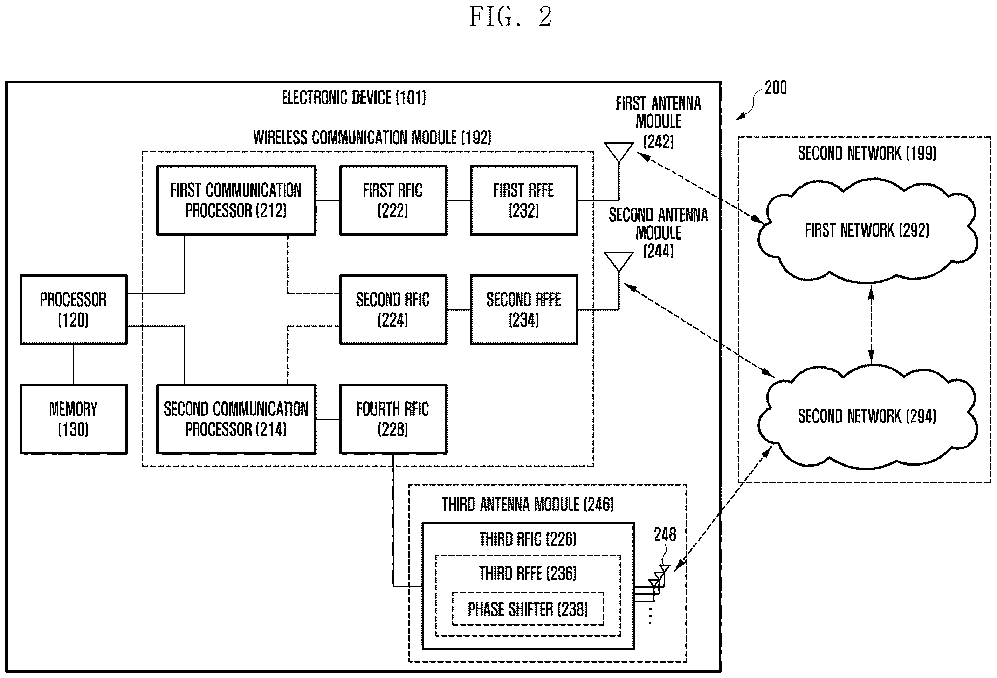

FIG. 2 is a block diagram 200 illustrating an example configuration of the electronic device 101 for supporting legacy network communication and 5G network communication according to various embodiments.

Referring to FIG. 2, the electronic device 101 may include a first communication processor (e.g., including processing circuitry) 212, a second communication processor (e.g., including processing circuitry) 214, a first radio frequency integrated circuit (RFIC) 222, a second RFIC 224, a third RFIC 226, a fourth RFIC 228, a first radio frequency front end (RFFE) 232, a second RFFE 234, a first antenna module (e.g., including at least one antenna) 242, a second antenna module (e.g., including at least one antenna) 244, and antennas 248. The electronic device 101 may further include the processor (e.g., including processing circuitry) 120 and the memory 130. The network 199 may include a first network 292 and a second network 294. According to an embodiment, the electronic device 101 may further include at least one of the components illustrated in FIG. 1, and the network 199 may further include at least one other network. According to an embodiment, the first communication processor 212, the second communication processor 214, the first RFIC 222, the second RFIC 224, the fourth RFIC 228, the first RFFE 232, and the second RFFE 234 may form at least a part of the wireless communication module 192. According to an embodiment, the fourth RFIC 228 may be omitted, or may be included as a part of the third RFIC 226.

The first communication processor 212 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. The first communication processor 212 may, for example, support establishment of a communication channel of a band to be used for wireless communication with the first network 292, and legacy network communication via the established communication channel. According to various embodiments, the first network 292 may be a legacy network including a second generation (2G), 3G, 4G, or long-term evolution (LTE) network. The second communication processor 214 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. The second communication processor 214 may, for example, support establishment of a communication channel corresponding to a designated band (e.g., about 6 GHz to about 60 GHz) among bands to be used for wireless communication with the second network 294, and 5G network communication via the established communication channel. According to various embodiments, the second network 294 may be a 5G network defined by 3GPP. In addition, according to an embodiment, the first communication processor 212 or the second communication processor 214 may support establishment of a communication channel corresponding to another designated band (e.g., about 6 GHz or lower) among the bands to be used for wireless communication with the second network 294, and 5G network communication via the established communication channel. According to an embodiment, the first communication processor 212 and the second communication processor 214 may be implemented within a single chip or a single package. According to various embodiments, the first communication processor 212 or the second communication processor 214 may be implemented, within a single chip or a single package, together with the processor 120, the auxiliary processor 123, or the communication module 190.

The first RFIC 222 may convert, during transmission, a baseband signal generated by the first communication processor 212 into a radio frequency (RF) signal of about 700 MHz to about 3 GHz used for the first network 292 (e.g., a legacy network). During reception, the RF signal may be acquired from the first network 292 (e.g., the legacy network) via an antenna (e.g., the first antenna module 242) and may be preprocessed via RFFE (e.g., the first RFFE 232). The first RFIC 222 may convert the preprocessed RF signal into a baseband signal so as to be processed by the first communication processor 212.

The second RFIC 224 may convert, during transmission, a baseband signal generated by the first communication processor 212 or the second communication processor 214 into an RF signal (hereinafter, a 5G Sub6 RF signal) of a Sub6 band (e.g., about 6 GHz or lower) used for the second network 294 (e.g., a 5G network). During reception, the 5G Sub6 RF signal may be acquired from the second network 294 (e.g., the 5G network) via an antenna (e.g., the second antenna module 244) and may be preprocessed via RFFE (e.g., the second RFFE 234). The second RFIC 224 may convert the preprocessed 5G Sub6 RF signal into a baseband signal so as to be processed by a communication processor corresponding to one of the first communication processor 212 or the second communication processor 214.

The third RFIC 226 may convert a baseband signal generated by the second communication processor 214 into an RF signal (hereinafter, a 5G Above6 RF signal) of a 5G Above6 band (e.g., about 6 GHz to about 60 GHz) to be used in the second network 294 (e.g., the 5G network). During reception, the 5G Above6 RF signal may be acquired from the second network 294 (e.g., a 5G network) via an antenna (e.g., the antenna 248) and may be preprocessed via the third RFFE 236. The third RFIC 226 may convert the preprocessed 5G Above6 RF signal into a baseband signal so as to be processed by the second communication processor 214. According to an embodiment, the third RFFE 236 may be formed as a part of the third RFIC 226.

According to an embodiment, the electronic device 101 may include the fourth RFIC 228 separately from or as at least a part of the third RFIC 226. In this case, the fourth RFIC 228 may convert a baseband signal generated by the second communication processor 214 into an RF signal (hereinafter, an IF signal) of an intermediate frequency band (e.g., about 9 GHz to about 11 GHz), and then transfer the IF signal to the third RFIC 226. The third RFIC 226 may convert the IF signal into a 5G Above6 RF signal. During reception, the 5G Above6 RF signal may be received from the second network 294 (e.g., the 5G network) via an antenna (e.g., the antenna 248) and may be converted into an IF signal by the third RFIC 226. The fourth RFIC 228 may convert the IF signal into a baseband signal so as to be processed by the second communication processor 214.

According to an embodiment, the first RFIC 222 and the second RFIC 224 may be implemented as at least a part of a single package or a single chip. According to an embodiment, the first RFFE 232 and the second RFFE 234 may be implemented as at least a part of a single package or a single chip. According to an embodiment, at least one of the first antenna module 242 or the second antenna module 244 may be omitted, or may be combined with another antenna module so as to process RF signals in multiple corresponding bands.

According to an embodiment, the third RFIC 226 and the antenna 248 may be disposed on the same substrate so as to form a third antenna module 246. For example, the wireless communication module 192 or the processor 120 may be disposed on a first substrate (e.g., a main PCB). In this case, the third RFIC 226 may be disposed on a partial area (e.g., bottom surface) of a second substrate (e.g., a sub-PCB) separate from the first substrate, and the antenna 248 may be disposed on another partial area (e.g., top surface) of the second substrate, thereby forming the third antenna module 246. By placing the third RFIC 226 and the antenna 248 on the same substrate, it is possible to reduce a length of a transmission line therebetween. This, for example, may reduce the loss (e.g., attenuation), which is caused due to a transmission line, of a signal in a high frequency band (e.g., about 6 GHz to about 60 GHz) used for 5G network communication. Accordingly, the electronic device 101 may improve the quality or speed of communication with the second network 294 (e.g., the 5G network).

According to an embodiment, the antenna 248 may be formed as an antenna array including multiple antenna elements that may be used for beamforming. In this case, the third RFIC 226 may include, for example, multiple phase shifters 238 corresponding to the multiple antenna elements, as parts of the third RFFE 236. During transmission, each of the multiple phase shifters 238 may convert the phase of a 5G Above6 RF signal to be transmitted to the outside of the electronic device 101 (e.g., a base station of a 5G network) via a corresponding antenna element. During reception, each of the multiple phase shifters 238 may convert, into the same or substantially the same phase, the phase of the 5G Above6 RF signal received from the outside via the corresponding antenna element. This enables transmission or reception via beamforming between the electronic device 101 and the outside.

The second network 294 (e.g., the 5G network) may be operated independently of (e.g., stand-alone (SA)) or in connection with (e.g., non-stand-alone (NSA)) the first network 292 (e.g., the legacy network). For example, the 5G network may have only an access network (e.g., a 5G radio access network (RAN) or a next generation RAN (NG RAN)) and may not have a core network (e.g., a next generation core (NGC)). In this case, the electronic device 101 may access the access network of the 5G network and then access an external network (e.g., Internet) under the control of a core network (e.g., an evolved packed core (EPC)) of the legacy network. Protocol information (e.g., LTE protocol information) for communication with the legacy network or protocol information (e.g., new radio (NR) protocol information) for communication with the 5G network may be stored in the memory 130 and may be accessed by other components (e.g., the processor 120, the first communication processor 212, or the second communication processor 214).

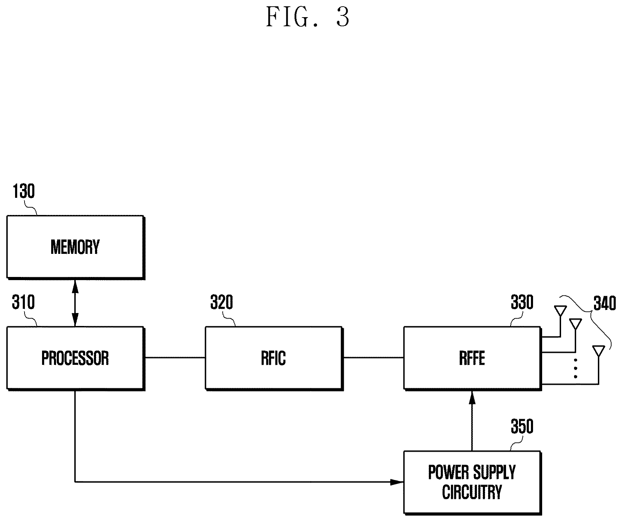

FIG. 3 is a block diagram illustrating an example configuration the electronic device 101 according to various embodiments.

In an embodiment, the electronic device 101 (e.g., the electronic device 101 of FIG. 1) may include the memory 130, a processor (e.g., including processing circuitry) 310 (e.g., the processor 120 of FIG. 1 or the processor 120 of FIG. 2), a radio frequency integrated circuit (RFIC) 320, a radio frequency front end (RFFE) circuitry 330, antennas 340, and power supply circuitry (e.g., power amplifier with power management (PAPM)) 350.

In an embodiment, the memory 130 may store instructions. The instructions may cause, when executed by the processor 310, the electronic device 101 to perform functions of FIG. 3, FIG. 4, FIG. 5, FIG. 6, FIG. 7, and/or FIG. 8.

In an embodiment, the processor 310 (e.g., the processor 120 of FIG. 1) may include various processing and control overall operations of the electronic device 101 and a signal flow between internal elements of the electronic device 101, and perform data processing. For example, the processor 310 may include a central processing unit (CPU), an application processor (AP) (e.g., the main processor 121 of FIG. 1), and/or a communication processor (CP) (e.g., the auxiliary processor 123 of FIG. 1).

In an embodiment, the RFIC 320 may up-convert a signal (e.g., a baseband signal or an intermediate frequency band signal) generated by the processor 310 into a radio signal and transfer the radio signal to the RFFE circuit 330. The RFFE circuit 330 may amplify the radio signal, which is received from the RFIC 320, to transmit the same to an external electronic device via the antennas 340. The processor 310 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions.

In an embodiment, the RFIC 320 may down-convert a radio signal preprocessed in the RFFE circuitry 330 to a baseband signal so as to be processed by the processor 310.

In an embodiment, the RFIC 320 may include the first RFIC 222 and the second RFIC 224 which are not illustrated in FIG. 3 but are illustrated in FIG. 2. The disclosure is not limited thereto, and the first RFIC 222 and the second RFIC 224 may be implemented as an integrated RFIC 320 when implemented as a single chip or a single package.

In an embodiment, the RFFE circuitry 330 may transmit frequency bands of a first communication network and/or a second communication network. The frequency bands of the first communication network and/or the second communication network may be identical or similar. However, the disclosure is not limited thereto, and the frequency bands of the first communication network and/or the second communication network may be different.

In an embodiment, the RFFE circuitry 330 may be designed to enable signal processing suitable for characteristics of the first communication network (e.g., a 4G communication network, a legacy communication network, or an LTE communication network) and the second communication network (e.g., a 5G communication network or a new radio (NR) communication network).

In an embodiment, the RFFE circuitry 330 (e.g., the first RFFE 232 of FIG. 2 and/or the second RFFE 234 of FIG. 2) may preprocess a radio signal received from an external electronic device via the antennas 340. For example, the RFFE circuitry 330 may amplify the radio signal received from the external electronic device via the antennas 340 while suppressing noise via a low noise amplifier (LNA).

In an embodiment, the antennas 340 may support frequency bands for the first communication network (e.g., the 4G communication network, the legacy communication network, or the LTE communication network) and the second communication network (e.g., the 5G communication network and the new radio (NR) communication network).

In an embodiment, the antennas 340 may transmit and/or receive radio signals of multiple frequency bands to and/or from external electronic devices. For example, the antennas 340 may support a first frequency band (e.g., about 1930 MHz to about 1990 MHz) and a second frequency band (e.g., about 1710 MHz to about 2200 MHz). However, the disclosed is not limited thereto.

In an embodiment, the antennas 340 may use, as a radiator, at least a portion of a housing (e.g., a side plate) of the electronic device 101 (e.g., at least a portion of the upper surface of the side plate and at least a portion of the lower surface of the side plate), or may use, as radiators, conductors (or conductive parts) within the housing, which are disposed adjacent to the housing. For example, the housing of the electronic device 101 may include at least one non-conductive portion and/or a conductive portion.

In an embodiment, the power supply circuitry 350 may provide power to multiple power amplifiers included in the RFFE circuitry 330. The power supply circuitry 350 may include multiple power source circuitries. For example, the multiple power source circuitries may be dedicatedly connected to the multiple power amplifiers.

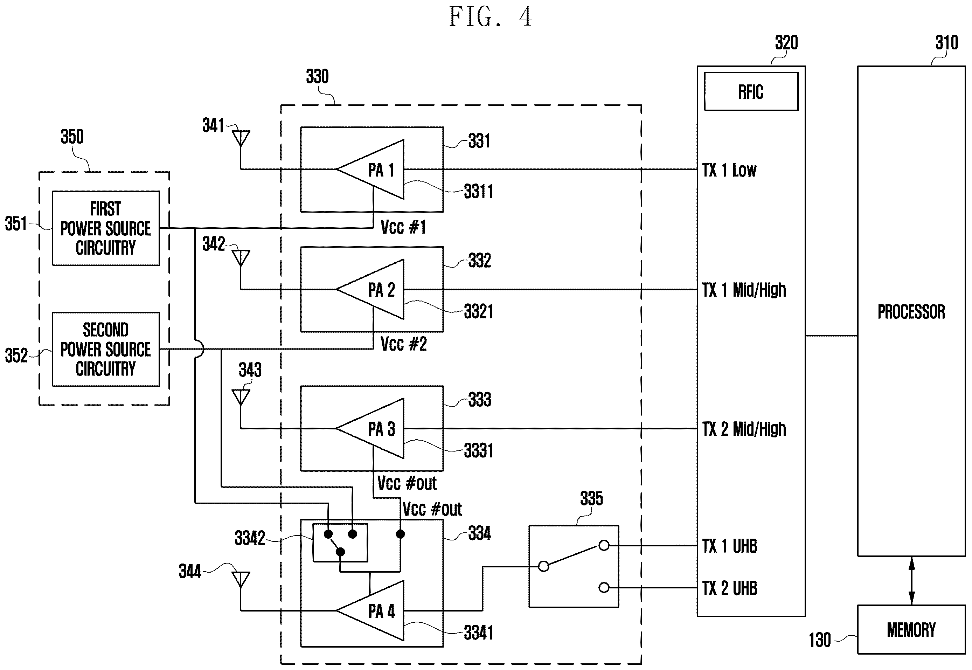

FIG. 4 is a diagram illustrating an example electronic device 101 according to various embodiments.

In an embodiment, the electronic device 101 (e.g., the electronic device 101 of FIG. 1) may include the memory 130, the processor (e.g., including processing circuitry) 310 (e.g., the processor 120 of FIG. 1 or the processor 120 of FIG. 2), the RFIC 320 (e.g., the RFIC 320 of FIG. 3), the RFFE circuitry 330, the antennas 340, and the power supply circuitry 350.

In an embodiment, the memory 130 may store instructions. The instructions may cause, when executed by the processor 310, the electronic device 101 to perform operations mentioned in FIG. 4.

In an embodiment, the processor 310 (e.g., the processor 120 of FIG. 1) may include various processing circuitry and generate a baseband signal or an intermediate frequency band signal for a first communication network or a second communication network and transfer the same to the RFIC 320.

In an embodiment, the RFIC 320 may include a first port (TX1 low), a second port (TX1 mid/high), a third port (TX2 mid/high), a fourth port (TX1 UHB), or a fifth port (TX2 UHB).

In an embodiment, the RFIC 320 may up-convert a radio signal for a first frequency band (LTE low) of the first communication network, a second frequency band (LTE mid) of the first communication network, a third frequency band (LTE high) of the first communication network, a first frequency band (NR low) of the second communication network, a second frequency band (NR mid) of the second communication network, a third frequency band (NR high) of the second communication network, or a fourth frequency band (NR UHB) of the second communication network, and transfer the up-converted radio signal to the RFFE circuitry 330.

In an embodiment, the RFFE circuitry 330 may include a first power amplification circuitry 331, a second power amplification circuitry 332, a third power amplification circuitry 333, a fourth power amplification circuitry 334, and/or a first switch 335.

In an embodiment, the first power amplification circuitry 331 may include a first power amplifier 3311. The second power amplification circuitry 332 may include a second power amplifier 3321. The third power amplification circuitry 333 may include a third power amplifier 3331. The fourth power amplification circuitry 334 may include a fourth power amplifier 3341 and a second switch 3342. However, the disclosure is not limited thereto, and the second switch 3342 may be disposed outside the RFEE circuitry 330 or outside the fourth power amplification circuitry 334.

In an embodiment, the antennas 340 may include a first antenna 341, a second antenna 342, a third antenna 343, and/or a fourth antenna 344.

In an embodiment, the power supply circuitry 350 may include first power source circuitry 351 and second power source circuitry 352.

In an embodiment, in order for the electronic device 101 to support an EN-DC function of simultaneously outputting multiple transmission signals, the ports and power amplifiers of the RFIC 320 may be configured to be dedicated or connected.

In an embodiment, the first port (TX1 low) of the RFIC 320 may be configured to be dedicated or connected to the first power source circuitry 351.

In an embodiment, the second port (TX1 mid/high) of the RFIC 320 may be configured to be dedicated or connected to the second power source circuitry 352.

In an embodiment, the third port (TX2 mid/high) of the RFIC 320 may be configured to be dedicated or connected to the first power source circuitry 351.

In an embodiment, the fourth port (TX1 UHB) of the RFIC 320 may be configured to be dedicated or connected to the first power source circuitry 351.

In an embodiment, the fifth port (TX2 UHB) of the RFIC 320 may be configured to be dedicated or connected to the second power source circuitry 352.

In an embodiment, the first frequency band (LTE low) of the first communication network and the first frequency band (NR low) of the second communication network may be identical or similar communication bands. For example, transmission signals of the first frequency band (LTE low) of the first communication network and the first frequency band (NR low) of the second communication network may be transferred to the first power amplifier 3311 via the first port (TX1 low) of the RFIC 320.

In an embodiment, the second frequency band (LTE mid) of the first communication network and the second frequency band (NR mid) of the second communication network may be identical or similar communication bands. For example, transmission signals of the second frequency band (LTE mid) of the first communication network and the second frequency band (NR mid) of the second communication network may be transferred to the second power amplifier 3321 or the third power amplifier 3331 via the second port (TX1 mid/high) or the third port (TX2 mid/high) of the RFIC 320.

In an embodiment, the third frequency band (LTE high) of the first communication network and the third frequency band (NR high) of the second communication network may be identical or similar communication bands. For example, transmission signals of the third frequency band (LTE high) of the first communication network and the third frequency band (NR high) of the second communication network may be transferred to the second power amplifier 3321 or the third power amplifier 3331 via the second port (TX1 mid/high) or the third port (TX2 mid/high) of the RFIC 320.

In an embodiment, the second communication network may include the fourth frequency band (NR UHB). For example, a transmission signal of the fourth frequency band (NR UHB) of the second communication network may be transferred to the fourth power amplifier 3341. According to an EN-DC support combination, the transmission signal of the fourth frequency band (NR UHB) of the second communication network may be transferred to the fourth power amplifier 3341 via the fourth port (TX1 UHB) or the fifth port (TX2 UHB).

In an embodiment, the first power amplifier 3311 may be connected to the RFIC 320, the first antenna 341, and the first power source circuitry 351. The first power amplifier 3311 may amplify a transmission signal output from the first port (TX1 low) of the RFIC 320 and transfer the amplified signal to the first antenna 341. The first antenna 341 may transmit the transmission signal output from the first port (TX1 low) of the RFIC 320 to the outside of the electronic device 101. The first power amplifier 3311 may receive power from the first power source circuitry 351 and amplify the transmission signal of the first port (TX1 low) of the RFIC 320.

In an embodiment, the second power amplifier 3321 may be connected to the RFIC 320, the second antenna 342, and the second power source circuitry 352. The second power amplifier 3321 may amplify a transmission signal output from the second port (TX1 mid/high) of the RFIC 320 and transfer the amplified signal to the second antenna 342. The second antenna 342 may transmit the transmission signal output from the second port (TX1 mid/high) of the RFIC 320 to the outside of the electronic device 101. The second power amplifier 3321 may receive power from the second power source circuitry 352 and amplify the transmission signal output from the second port (TX1 mid/high) of the RFIC 320.

In an embodiment, the third power amplifier 3331 may be connected to the RFIC 320, the third antenna 343, and the second switch 3342.

In an embodiment, the fourth power amplifier 3341 may be connected to the first switch 335, the fourth antenna 344, and the second switch 3342.

In an embodiment, the first switch 335 may be connected to the RFCI 320 and the fourth power amplifier 3341.

In an embodiment, the second switch 3342 may be connected to the first power source circuitry 351 and the second power source circuitry 352, so as to cause, under the control of the processor 310, one of the power source circuitries to supply power to the third power amplifier 3331 and the fourth power amplifier 3341.

In an embodiment, the instructions stored in the memory 130 may cause, when executed by processor 310, the electronic device 101 to supply, using one power source circuitry, power to the third power amplifier 3331 and the fourth power amplifier 3341.

In an embodiment, the third power amplifier 3331 may receive power from the first power source circuitry 351 or second power source circuitry 352 connected via the second switch 3342 and amplify a transmission signal output from the third port (TX2 mid/high) of the RFIC 320.

In an embodiment, the fourth power amplifier 3341 may receive power from the first power source circuitry 351 or second power source circuitry 352 connected via the second switch 3342 and amplify a transmission signal output from the fourth port (TX1 UHB) or the fifth port (TX2 UHB).

In an embodiment, when the first power source circuitry 351 or the second power source circuitry 352 is selected by the second switch 3342 under the control of the processor 310, the second switch 3342 may cause a first voltage (e.g., vcc#out) to be output. When the electronic device 101 performs the EN-DC function, the first voltage (e.g., vcc#out) may be changed to an output voltage of the first power source circuitry 351 or second power source circuitry 352 according to a corresponding frequency band.

In an embodiment, the instructions stored in the memory 130 may cause, when executed by the processor 310, the electronic device 101 to, when the first power source circuitry 351 or the second power source circuitry 352 is selected by the second switch 3342, output the first voltage (e.g., vcc#out) using the second switch 3342.

For example, descriptions will be provided in the following for a case in which, when the electronic device 101 performs the EN-DC function, the electronic device 101 simultaneously transmits the transmission signals of the first frequency band (LTE low) of the first communication network, the second frequency band (NR mid) of the second communication network, and the third frequency band (NR high) of the second communication network. The electronic device 101 may transmit the transmission signal of the first frequency band (LTE low) of the first communication network via the first antenna 341. The transmission signal of the first frequency band (LTE low) of the first communication network may be transferred to the first power amplifier 3311 via the first port (TX1 low). The first power amplifier 3311 may receive power via the first power source circuitry 351. The electronic device 101 may transmit the transmission signals of the second frequency band (NR mid) of the second communication network and the third frequency band (NR high) of the second communication network via the second antenna 342. The transmission signals of the second frequency band (NR mid) of the second communication network and the third frequency band (NR high) of the second communication network may be transferred to the second power amplifier 3321 via the second port (TX1 mid/high). The second power amplifier 3321 may receive power via the second power source circuitry 352.

For example, descriptions will be provided in the following for a case in which, when the electronic device 101 performs the EN-DC function, the electronic device 101 simultaneously transmits the transmission signals of the first frequency band (LTE low) of the first communication network and the fourth frequency band (NR UHB) of the second communication network.

In an embodiment, the electronic device 101 may transmit the transmission signal of the first frequency band (LTE low) of the first communication network via the first antenna 341. The transmission signal of the first frequency band (LTE low) of the first communication network may be transferred to the first power amplifier 3311 via the first port (TX1 low). The first power amplifier 3311 may receive power via the first power source circuitry 351. The electronic device 101 may transmit the transmission signal of the fourth frequency band (NR UHB) of the second communication network via the fourth antenna 344. The transmission signal of the fourth frequency band (NR UHB) of the second communication network may be transferred to the fourth power amplifier 3341 via the fifth port (TX2 UHB). The fourth power amplifier 3341 may receive power via the second power source circuitry 352. For example, since the first port (TX1 low) is configured to be dedicated to the first power source circuitry 351, the electronic device 101 may change a power connection of the second switch 3342 to the second power source circuitry 352 under the control of the processor 310. The fourth power amplifier 3341 may amplify, based on the power supplied from the second power source circuitry 352, the transmission signal output from the fifth port (TX2 UHB) and output the amplified signal to the fourth antenna 344. In an embodiment, the instructions stored in the memory 130 may cause, when executed by processor 310, the electronic device 101 to change a power connection of the second switch 3342 to the second power source circuitry 352.

For example, descriptions will be provided in the following for a case in which, when the electronic device 101 performs the EN-DC function, the electronic device 101 simultaneously transmits the transmission signals of the second frequency band (LTE mid) of the first communication network and the first frequency band (NR low) of the second communication network.

In an embodiment, the electronic device 101 may transmit the transmission signals of the second frequency band (LTE mid) and third frequency band (LTE high) of the first communication network via the second antenna 342. The transmission signals of the second frequency band (LTE mid) and third frequency band (LTE high) of the first communication network may be transferred to the second power amplifier 3321 via the second port (TX1 mid/high). The second power amplifier 3321 may receive power via the second power source circuitry 352. The electronic device 101 may transmit the transmission signal of the first frequency band (NR low) of the second communication network via the first antenna 341. The transmission signal of the first frequency band (NR low) of the second communication network may be transferred to the first power amplifier 3311 via the first port (TX1 low). The first power amplifier 3311 may receive power via the first power source circuitry 351.

For example, descriptions will be provided in the following for a case in which, when the electronic device 101 performs the EN-DC function, the electronic device 101 simultaneously transmits the transmission signals of the second frequency band (LTE mid) of the first communication network and the second frequency band/third frequency band (NR mid/high) of the second communication network.

In an embodiment, the electronic device 101 may transmit the transmission signal of the second frequency band (LTE mid) of the first communication network via the third antenna 343. The transmission signal of the second frequency band (LTE mid) of the first communication network may be transferred to the third power amplifier 3331 via the third port (TX2 mid/high). The third power amplifier 3331 may receive power via the first power source circuitry 351. The electronic device 101 may transmit the transmission signal of the second frequency band/third frequency band (NR mid/high) of the second communication network via the second antenna 342. The transmission signal of the second frequency band/third frequency band (NR mid/high) of the second communication network may be transferred to the second power amplifier 3321 via the second port (TX1 mid/high). The second power amplifier 3321 may receive power via the second power source circuitry 352. For example, since the second port (TX1 mid/high) is configured to be dedicated to the second power source circuitry 352, the electronic device 101 may change a power connection of the second switch 3342 to the first power source circuitry 351 under the control of the processor 310. The third power amplifier 3331 may amplify, based on the power supplied from the first power source circuitry 351, the transmission signal output from the third port (TX2 mid/high) and output the amplified signal to the third antenna 343. In an embodiment, since the second port (TX1 mid/high) is configured to be dedicated to the second power source circuitry 352, the instructions stored in the memory 130 may cause, when executed by the processor 310, the electronic device 101 to change a power connection of the second switch 3342 to the first power source circuitry 351.

For example, descriptions will be provided in the following for a case in which, when the electronic device 101 performs the EN-DC function, the electronic device 101 simultaneously transmits the transmission signals of the second frequency band (LTE mid) of the first communication network and the fourth frequency band (NR UHB) of the second communication network.

In an embodiment, the electronic device 101 may transmit the transmission signal of the second frequency band (LTE mid) of the first communication network via the second antenna 342. The transmission signal of the second frequency band (LTE mid) of the first communication network may be transferred to the second power amplifier 3321 via the second port (TX1 mid/high). The second power amplifier 3321 may receive power via the second power source circuitry 352. The electronic device 101 may transmit the transmission signal of the fourth frequency band (NR UHB) of the second communication network via the fourth antenna 344. The transmission signal of the fourth frequency band (NR UHB) of the second communication network may be transferred to the fourth power amplifier 3341 via the fourth port (TX1 UHB). The fourth power amplifier 3341 may receive power via the first power source circuitry 351. For example, since the second port (TX1 mid/high) is configured to be dedicated to the second power source circuitry 352, the electronic device 101 may change a power connection of the second switch 3342 to the first power source circuitry 351 under the control of the processor 310. Since the second port (TX1 mid/high) is configured to be dedicated to the second power source circuitry 352, the instructions stored in the memory 130 may cause, when executed by the processor 310, the electronic device 101 to change a power connection of the second switch 3342 to the first power source circuitry 351.

The fourth power amplifier 3341 may amplify, based on the power supplied from the first power source circuitry 351, the transmission signal output from the fourth port (TX1 UHB) and output the amplified signal to the fourth antenna 344. The electronic device 101 may control the first switch 335 so that, when the first power source circuitry 351 supplies power to the fourth power amplifier 3341, the transmission signal from the fourth port (TX1 UHB) is transferred to the fourth power amplifier 3341. The electronic device 101 may control the first switch 335 so that, when the second power source circuitry 352 supplies power to the fourth power amplifier 3341, the transmission signal from the fifth port (TX2 UHB) is transferred to the fourth power amplifier 3341.

For example, descriptions will be provided in the following for a case in which, when the electronic device 101 performs the EN-DC function, the electronic device 101 simultaneously transmits the transmission signals of the third frequency band (LTE high) of the first communication network and the first frequency band (NR low) of the second communication network.

In an embodiment, the electronic device 101 may transmit the transmission signal of the third frequency band (LTE high) of the first communication network via the second antenna 342. The transmission signal of the third frequency band (LTE high) of the first communication network may be transferred to the second power amplifier 3321 via the second port (TX1 mid/high). The second power amplifier 3321 may receive power via the second power source circuitry 352. The electronic device 101 may transmit the transmission signal of the first frequency band (NR low) of the second communication network via the first antenna 341. The transmission signal of the first frequency band (NR low) of the second communication network may be transferred to the first power amplifier 3311 via the first port (TX1 low). The first power amplifier 3311 may receive power via the first power source circuitry 351.

For example, descriptions will be provided in the following for a case in which, when the electronic device 101 performs the EN-DC function, the electronic device 101 simultaneously transmits the transmission signals of the third frequency band (LTE high) of the first communication network and the second frequency band (NR mid) of the second communication network.

In an embodiment, the electronic device 101 may transmit the transmission signal of the third frequency band (LTE high) of the first communication network via the third antenna 343. The transmission signal of the third frequency band (LTE high) of the first communication network may be transferred to the third power amplifier 3331 via the third port (TX2 mid/high). The third power amplifier 3331 may receive power via the first power source circuitry 351. The electronic device 101 may transmit the transmission signal of the second frequency band (NR mid) of the second communication network via the second antenna 342. The transmission signal of the second frequency band (NR mid) of the second communication network may be transferred to the second power amplifier 3321 via the second port (TX1 mid/high). The second power amplifier 3321 may receive power via the second power source circuitry 352. For example, since the second port (TX1 mid/high) is configured to be dedicated to the second power source circuitry 352, the electronic device 101 may change a power connection of the second switch 3342 to the first power source circuitry 351 under the control of the processor 310. Since the second port (TX1 mid/high) is configured to be dedicated to the second power source circuitry 352, the instructions stored in the memory 130 may cause, when executed by the processor 310, the electronic device 101 to change a power connection of the second switch 3342 to the first power source circuitry 351. The third power amplifier 3331 may amplify, based on the power supplied from the first power source circuitry 351, the transmission signal output from the third port (TX2 mid/high) and output the amplified signal to the third antenna 343.

For example, descriptions will be provided in the following for a case in which, when the electronic device 101 performs the EN-DC function, the electronic device 101 simultaneously transmits the transmission signals of the third frequency band (LTE high) of the first communication network and the fourth frequency band (NR UHB) of the second communication network.

In an embodiment, the electronic device 101 may transmit the transmission signal of the third frequency band (LTE high) of the first communication network via the second antenna 342. The transmission signal of the third frequency band (LTE high) of the first communication network may be transferred to the second power amplifier 3321 via the second port (TX1 mid/high). The second power amplifier 3321 may receive power via the second power source circuitry 352. The electronic device 101 may transmit the transmission signal of the fourth frequency band (NR UHB) of the second communication network via the fourth antenna 344. The transmission signal of the fourth frequency band (NR UHB) of the second communication network may be transferred to the fourth power amplifier 3341 via the fourth port (TX1 UHB). The fourth power amplifier 3341 may receive power via the first power source circuitry 351. For example, since the second port (TX1 mid/high) is configured to be dedicated to the second power source circuitry 352, the electronic device 101 may change a power connection of the second switch 3342 to the first power source circuitry 351 under the control of the processor 310. Since the second port (TX1 mid/high) is configured to be dedicated to the second power source circuitry 352, the instructions stored in the memory 130 may cause, when executed by the processor 310, the electronic device 101 to change a power connection of the second switch 3342 to the first power source circuitry 351. The fourth power amplifier 3341 may amplify, based on the power supplied from the first power source circuitry 351, the transmission signal output from the fourth port (TX2 UHB) and output the amplified signal to the fourth antenna 344.

For example, descriptions will be provided in the following for a case in which, when the electronic device 101 performs a transmission hopping (TX hopping) function, the electronic device 101 simultaneously transmits the transmission signals of the second frequency band (LTE mid) of the first communication network and the second frequency band/third frequency band (NR mid/high) of the second communication network.

In an embodiment, when performing the EN-DC function, the electronic device 101 may transmit the transmission signal of the second frequency band (LTE mid) of the first communication network via the third antenna 343. In order to increase antenna efficiency in the same frequency band, the electronic device 101 may perform the TX hopping function.

In an embodiment, when performing the TX hopping function, the electronic device 101 may transmit the transmission signal of the second frequency band (LTE mid) of the first communication network via the second antenna 342.

When an antenna is changed from the third antenna 343 to the second antenna 342, the transmission signal of the second frequency band (LTE mid) of the first communication network may be transferred to the second power amplifier 3321 via the second port (TX1 mid/high). The second power amplifier 3321 may receive power via the second power source circuitry 352.

When the electronic device 101 transmits the transmission signal of the second frequency band (LTE mid) of the first communication network via the second antenna 342, the electronic device 101 may transmit the transmission signal of the second frequency band/third frequency band (NR mid/high) of the second communication network using the third antenna 343 instead of the second antenna 342. The transmission signal of the second frequency band/third frequency band (NR mid/high) of the second communication network may be transferred to the third power amplifier 3331 via the third port (TX2 mid/high). The third power amplifier 3331 may receive power via the first power source circuitry 351. For example, since the second port (TX1 mid/high) is configured to be dedicated to the second power source circuitry 352, the electronic device 101 may change a power connection of the second switch 3342 to the first power source circuitry 351 under the control of the processor 310. Since the second port (TX1 mid/high) is configured to be dedicated to the second power source circuitry 352, the instructions stored in the memory 130 may cause, when executed by the processor 310, the electronic device 101 to change a power connection of the second switch 3342 to the first power source circuitry 351. The third power amplifier 3331 may amplify, based on the power supplied from the first power source circuitry 351, the transmission signal output from the third port (TX2 mid/high) and output the amplified signal to the third antenna 343.

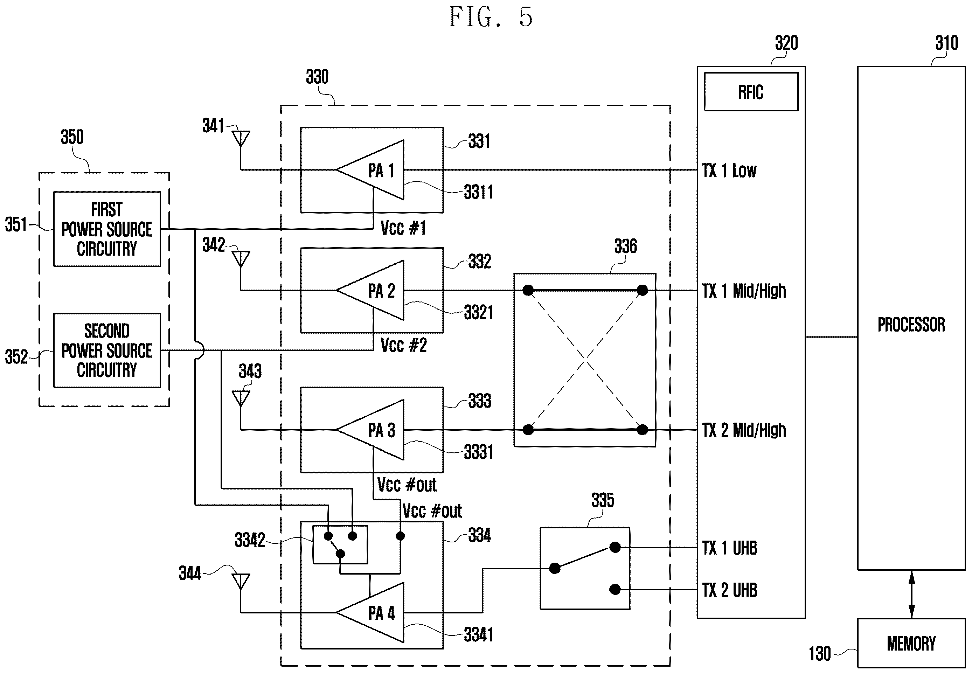

FIG. 5 is a diagram illustrating an example electronic device 101 according to various embodiments.

In an embodiment, the electronic device 101 (e.g., the electronic device 101 of FIG. 1) may include the memory 130, the processor (e.g., including processing circuitry) 310 (e.g., the processor 120 of FIG. 1 or the processor 120 of FIG. 2), the RFIC 320 (e.g., the RFIC 320 of FIG. 3), the RFFE circuitry 330, the antennas 340, and the power supply circuitry 350.

In an embodiment, the memory 130 may store instructions. The instructions may cause, when executed by the processor 310, the electronic device 101 to perform operations mentioned in FIG. 5.

The electronic device 101 of FIG. 5 may further include a third switch 336 in the RFFE circuit 330 in comparison with the electronic device 101 of FIG. 4. When describing the electronic device 101 of FIG. 5, content overlapping with that of the electronic device 101 of FIG. 4 may be omitted.

In an embodiment, the RFFE circuitry 330 may include the first power amplification circuitry 331, the second power amplification circuitry 332, the third power amplification circuitry 333, the fourth power amplification circuitry 334, the first switch 335, the second switch 3342, and the third switch 336. For example, the third switch 336 may include a double pole double throw (DPDT) switch.

In an embodiment, the first power amplification circuitry 331 may include the first power amplifier 3311. The second power amplification circuitry 332 may include the second power amplifier 3321. The third power amplification circuitry 333 may include the third power amplifier 3331. The fourth power amplification circuitry 334 may include the fourth power amplifier 3341 and the second switch 3342. However, the disclosure is not limited thereto, and the second switch 3342 may be disposed outside the RFEE circuitry 330 or outside the fourth power amplification circuitry 334.

In an embodiment, the antennas 340 may include the first antenna 341, the second antenna 342, the third antenna 343, and the fourth antenna 344.

In an embodiment, the power supply circuitry 350 may include the first power source circuitry 351 and the second power source circuitry 352.

In an embodiment, in order for the electronic device 101 to support the EN-DC function of simultaneously outputting multiple transmission signals, the ports and power amplifiers of the RFIC 320 may be configured to be dedicated or connected.

In an embodiment, the first port (TX1 low) of the RFIC 320 may be configured to be dedicated or connected to the first power source circuitry 351.

In an embodiment, the second port (TX1 mid/high) of the RFIC 320 may be configured to be dedicated or connected to the second power source circuitry 352.

In an embodiment, the third port (TX2 mid/high) of the RFIC 320 may be configured to be dedicated or connected to the first power source circuitry 351.

In an embodiment, the fourth port (TX1 UHB) of the RFIC 320 may be configured to be dedicated or connected to the first power source circuitry 351.

In an embodiment, the fifth port (TX2 UHB) of the RFIC 320 may be configured to be dedicated or connected to the second power source circuitry 352.

In an embodiment, the first power amplifier 3311 may be connected to the RFIC 320, the first antenna 341, and the first power source circuitry 351. The first power amplifier 3311 may amplify a transmission signal output from the first port (TX1 low) of the RFIC 320 and transfer the amplified signal to the first antenna 341. The first antenna 341 may transmit the transmission signal output from the first port (TX1 low) of the RFIC 320 to the outside of the electronic device 101. The first power amplifier 3311 may receive power from the first power source circuitry 351 and amplify the transmission signal of the first port (TX1 low) of the RFIC 320.

In an embodiment, the second power amplifier 3321 may be connected to the second power source circuitry 352, the second antenna 342, and the third switch 336 that is connected to the RFIC 320. The second power amplifier 3321 may amplify a transmission signal output from the second port (TX1 mid/high) or a transmission signal output from the third port (TX2 mid/high), and transfer the amplified signal to the second antenna 342. The second antenna 342 may transmit, to the outside of the electronic device 101, the transmission signal output from the second port (TX1 mid/high) or the transmission signal output from the third port (TX2 mid/high). The second power amplifier 3321 may receive power from the second power source circuitry 352, and amplify the transmission signal output from the second port (TX1 mid/high) of the RFIC 320 or the transmission signal output from the third port (TX2 mid/high) of the RFIC 320.

In an embodiment, the third power amplifier 3331 may be connected to the second switch 3342, the third antenna 343, and the third switch 336 that is connected to the RFIC 320.

In an embodiment, the fourth power amplifier 3341 may be connected to the RFIC 320, the fourth antenna 344, and the second switch 3342.

In an embodiment, the second switch 3342 may be connected to the first power source circuitry 351 and the second power source circuitry 352, so as to cause, under the control of the processor 310, one of the power source circuitries to supply power to the third power amplifier 3331 and the fourth power amplifier 3341.

In an embodiment, the instructions stored in the memory 130 may cause, when executed by processor 310, the electronic device 101 to control the second switch 3342 so that one of the power source circuitries supplies power to the third power amplifier 3331 and the fourth power amplifier 3341.

In an embodiment, the third power amplifier 3331 may receive power from the first power source circuitry 351 or second power source circuitry 352 connected via the second switch 3342 and amplify a transmission signal output from the second port (TX1 mid/high) or a transmission signal output from the third port (TX2 mid/high).

In an embodiment, the fourth power amplifier 3341 may receive power from the first power source circuitry 351 or second power source circuitry 352 connected via the second switch 3342 and amplify a transmission signal output from the fourth port (TX1 UHB) or the fifth port (TX2 UHB).

In an embodiment, when the first power source circuitry 351 or the second power source circuitry 352 is selected by the second switch 3342 under the control of the processor 310, the second switch 3342 may cause a first voltage (e.g., vcc#out) to be output. When the electronic device 101 performs the EN-DC function, the first voltage (e.g., vcc#out) may be changed to an output voltage of the first power source circuitry 351 or second power source circuitry 352 according to a corresponding frequency band.

In an embodiment, the instructions stored in the memory 130 may cause, when executed by processor 310, the electronic device 101 to control the second switch 3342 so as to select the first power source circuitry 351 or the second power source circuitry 352. When the first power source circuitry 351 or the second power source circuitry 352 is selected by the second switch 3342, the second switch 3342 may cause the first voltage (e.g., vcc#out) to be output. When the electronic device 101 performs the EN-DC function, the first voltage (e.g., vcc#out) may be changed to an output voltage of the first power source circuitry 351 or second power source circuitry 352 according to a corresponding frequency band.

In an embodiment, the operation of performing the EN-DC function by the electronic device 101 of FIG. 5 may be substantially the same as that performed by the electronic device 101 of FIG. 4. In this case, the third switch 336 may connect the second port (TX1 mid/high) to the second power amplifier 3321, and connect the third port (TX2 mid/high) to the third power amplifier 3331.

For example, descriptions will be provided in the following for a case in which, when the electronic device 101 performs the transmission hopping (TX hopping) function, the electronic device 101 simultaneously transmits the transmission signals of the second frequency band (LTE mid) of the first communication network and the second frequency band/third frequency band (NR mid/high) of the second communication network.

In an embodiment, when performing the EN-DC function, the electronic device 101 may transmit the transmission signal of the second frequency band (LTE mid) of the first communication network via the third antenna 343. In order to increase antenna efficiency in the same frequency band, the electronic device 101 may perform the TX hopping function.

In an embodiment, when performing the TX hopping function, the electronic device 101 may transmit the transmission signal of the second frequency band (LTE mid) of the first communication network via the second antenna 342.

In an embodiment, when an antenna that transmits a transmission signal is changed from the third antenna 343 to the second antenna 342, the third port (TX2 mid/high) may be connected to the second power amplifier 3321 via the third switch 336. The transmission signal of the second frequency band (LTE mid) of the first communication network may be transferred to the second power amplifier 3321 via the third port (TX2 mid/high) and the third switch 336. Under the control of the processor 310, the electronic device 101 may control the third switch 336 to connect the third port (TX2 mid/high) and the second power amplifier 3321.

In an embodiment, the instructions stored in the memory 130 may cause, when executed by processor 310, the electronic device 101 to enable the third switch 336 to connect the third port (TX2 mid/high) and the second power amplifier 3321.

The second power amplifier 3321 may receive power via the second power source circuitry 352.

When the electronic device 101 transmits the transmission signal of the second frequency band (LTE mid) of the first communication network via the second antenna 342, the electronic device 101 may transmit the transmission signal of the second frequency band/third frequency band (NR mid/high) of the second communication network using the third antenna 343 instead of the second antenna 342. The transmission signal of the second frequency band/third frequency band (NR mid/high) of the second communication network may be transferred to the third power amplifier 3331 via the second port (TX1 mid/high) and the third switch 336. The third power amplifier 3331 may receive power via the first power source circuitry 351. Under the control of the processor 310, the electronic device 101 may control the third switch 336 to connect the second port (TX1 mid/high) and the third power amplifier 3331. In an embodiment, the instructions stored in the memory 130 may cause, when executed by processor 310, the electronic device 101 to enable the third switch 336 to connect the second port (TX1 mid/high) and the third power amplifier 3331. Since the second port (TX1 mid/high) is configured to be dedicated to the second power source circuitry 352, the electronic device 101 may change a power connection of the second switch 3342 to the first power source circuitry 351 under the control of the processor 310. Since the second port (TX1 mid/high) is configured to be dedicated to the second power source circuitry 352, the instructions stored in the memory 130 may cause, when executed by the processor 310, the electronic device 101 to change a power connection of the second switch 3342 to the first power source circuitry 351. The third power amplifier 3331 may amplify, based on the power supplied from the first power source circuitry 351, the transmission signal output from the second port (TX1 mid/high) and transferred via the third switch 336, and output the amplified signal to the third antenna 343.

For example, descriptions will be provided in the following for a case in which, when the electronic device 101 performs the transmission hopping (TX hopping) function, the electronic device 101 simultaneously transmits the transmission signals of the second frequency band (LTE mid) of the first communication network and the first frequency band (NR low) of the second communication network.

In an embodiment, when performing the EN-DC function, the electronic device 101 may transmit the transmission signal of the second frequency band (LTE mid) of the first communication network via the second antenna 342. In order to increase antenna efficiency in the same frequency band, the electronic device 101 may perform the TX hopping function.

In an embodiment, when performing the TX hopping function, the electronic device 101 may transmit the transmission signal of the second frequency band (LTE mid) of the first communication network via the third antenna 343.

When an antenna is changed from the second antenna 342 to the third antenna 343, the transmission signal of the second frequency band (LTE mid) of the first communication network may be transferred to the third power amplifier 3331 via the second port (TX1 mid/high). The third power amplifier 3331 may receive power via the second power source circuitry 352. The electronic device 101 may control, via the processor 310, the third switch 336 to connect the second port (TX1 mid/high) and the third power amplifier 3331. The instructions stored in the memory 130 may cause, when executed by processor 310, the electronic device 101 to enable the third switch 336 to connect the second port (TX1 mid/high) and the third power amplifier 3331.

The electronic device 101 may transmit the transmission signal of the first frequency band (NR low) of the second communication network using the first antenna 341. The transmission signal of the first frequency band (NR low) of the second communication network may be transferred to the first power amplifier 3311 via the first port (TX1 low). The first power amplifier 3311 may receive power via the first power source circuitry 351.

The electronic device 101 of FIG. 5 may change the connection between the port (e.g., the second port (TX 1 mid/high) or the third port (TX2 mid/high)) of the RFIC 320 and the power amplifier (e.g., the second power amplifier 3321 or the third power amplifier 3331) using the third switch 336, so as to include an antenna change combination enabling TX hopping, in comparison with the electronic device 101 of FIG. 4.

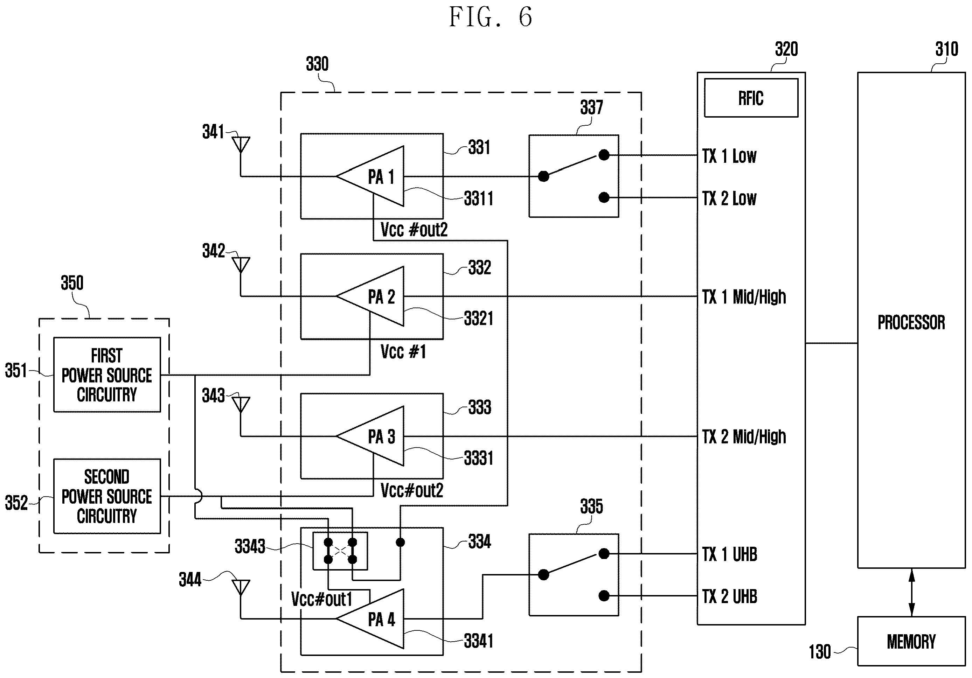

FIG. 6 is a diagram illustrating an example electronic device 101 according to various embodiments.

In an embodiment, the electronic device 101 (e.g., the electronic device 101 of FIG. 1) may include the memory 130, the processor (e.g., including processing circuitry) 310 (e.g., the processor 120 of FIG. 1 or the processor 120 of FIG. 2), the RFIC 320 (e.g., the RFIC 320 of FIG. 3), the RFFE circuitry 330, the antennas 340, and the power supply circuitry 350.

In an embodiment, the memory 130 may store instructions. The instructions may cause, when executed by the processor 310, the electronic device 101 to perform operations mentioned in FIG. 6.

In an embodiment, the processor 310 (e.g., the processor 120 of FIG. 1) may generate a baseband signal or an intermediate frequency band signal for a first communication network or a second communication network and transfer the same to the RFIC 320.

In an embodiment, the RFIC 320 may include a first port (TX1 low), a second port (TX1 mid/high), a third port (TX2 mid/high), a fourth port (TX1 UHB), a fifth port (TX2 UHB), or a sixth port (TX2 low). The RFIC 320 of FIG. 6 may further include the sixth port (TX2 low) in comparison with the RFIC 320 of FIG. 4 or FIG. 5.

In an embodiment, the RFIC 320 may up-convert a radio signal for a first frequency band (LTE low) of the first communication network, a second frequency band (LTE mid) of the first communication network, a third frequency band (LTE high) of the first communication network, a first frequency band (NR low) of the second communication network, a second frequency band (NR mid) of the second communication network, a third frequency band (NR high) of the second communication network, or a fourth frequency band (NR UHB) of the second communication network, and transfer the up-converted radio signal to the RFFE circuitry 330.

In an embodiment, the RFFE circuitry 330 may include the first power amplification circuitry 331, the second power amplification circuitry 332, the third power amplification circuitry 333, the fourth power amplification circuitry 334, the first switch 335, a fourth switch 3343, and a fifth switch 337. In comparison with the RFFE circuitry 330 of FIG. 4, the RFFE circuitry 330 of FIG. 6 may further include the fifth switch 337, and include the fourth switch 3343 instead of the second switch 3342.

In an embodiment, the first power amplification circuitry 331 may include the first power amplifier 3311. The second power amplification circuitry 332 may include the second power amplifier 3321. The third power amplification circuitry 333 may include the third power amplifier 3331. The fourth power amplification circuitry 334 may include the fourth power amplifier 3341 and the fourth switch 3343. For example, the fourth switch 3343 may include a DPDT type switch. However, the disclosure is not limited thereto, and the fourth switch 3343 may be disposed outside the RFEE circuitry 330 or outside the fourth power amplification circuitry 334.

In an embodiment, the antennas 340 may include the first antenna 341, the second antenna 342, the third antenna 343, and the fourth antenna 344.

In an embodiment, the power supply circuitry 350 may include the first power source circuitry 351 and the second power source circuitry 352.

In an embodiment, in order for the electronic device 101 to support the EN-DC function of simultaneously outputting multiple transmission signals, the ports and power amplifiers of the RFIC 320 may be configured to be dedicated or connected.

In an embodiment, the first port (TX1 low) of the RFIC 320 may be configured to be dedicated or connected to the first power source circuitry 351.

In an embodiment, the sixth port (TX2 low) of the RFIC 320 may be configured to be dedicated or connected to the second power source circuitry 352.

In an embodiment, the second port (TX1 mid/high) of the RFIC 320 may be configured to be dedicated or connected to the first power source circuitry 351.

In an embodiment, the third port (TX2 mid/high) of the RFIC 320 may be configured to be dedicated or connected to the second power source circuitry 352.

In an embodiment, the fourth port (TX1 UHB) of the RFIC 320 may be configured to be dedicated or connected to the first power source circuitry 351.

In an embodiment, the fifth port (TX2 UHB) of the RFIC 320 may be configured to be dedicated or connected to the second power source circuitry 352.

In an embodiment, the first frequency band (LTE low) of the first communication network and the first frequency band (NR low) of the second communication network may be identical or similar communication bands. For example, transmission signals of the first frequency band (LTE low) of the first communication network and the first frequency band (NR low) of the second communication network may be transferred to the first power amplifier 3311 via the first port (TX1 low) or sixth port (TX2 low) of the RFIC 320.

In an embodiment, the second frequency band (LTE mid) of the first communication network and the second frequency band (NR mid) of the second communication network may be identical or similar communication bands. For example, transmission signals of the second frequency band (LTE mid) of the first communication network and the second frequency band (NR mid) of the second communication network may be transferred to a power amplifier (e.g., the second power amplifier 3321 or the third power amplifier 3331) via the second port (TX1 mid/high) or third port (TX2 mid/high) of the RFIC 320.

In an embodiment, the third frequency band (LTE high) of the first communication network and the third frequency band (NR high) of the second communication network may be identical or similar communication bands. For example, transmission signals of the third frequency band (LTE high) of the first communication network and the third frequency band (NR high) of the second communication network may be transferred to a power amplifier (the second power amplifier 3321 or the third power amplifier 3331) via the second port (TX1 mid/high) or third port (TX2 mid/high) of the RFIC 320.

In an embodiment, the second communication network may include the fourth frequency band (NR UHB). For example, a transmission signal of the fourth frequency band (NR UHB) of the second communication network may be transferred to the fourth power amplifier 3341. According to an EN-DC support combination, the transmission signal of the fourth frequency band (NR UHB) of the second communication network may be transferred to the fourth power amplifier 3341 via the fourth port (TX1 UHB) or the fifth port (TX2 UHB).

In an embodiment, the first power amplifier 3311 may be connected to the fifth switch 337, the first antenna 341, and the first power source circuitry 351 via the fourth switch 3343. The first power amplifier 3311 may amplify a transmission signal output from the first port (TX1 low) or sixth port (TX2 low) of the RFIC 320 and transfer the amplified signal to the first antenna 341. The first antenna 341 may transmit the transmission signal output from the first port (TX1 low) or sixth port (TX2 low) of the RFIC 320 to the outside of the electronic device 101. The first power amplifier 3311 may receive power from the first power source circuitry 351 and/or the second power source circuitry 352, and amplify the transmission signal of the first port (TX1 low) or the sixth port (TX2 low).

In an embodiment, the second power amplifier 3321 may be connected to the RFIC 320, the second antenna 342, and the first power source circuitry 351. The second power amplifier 3321 may amplify a transmission signal output from the second port (TX1 mid/high) of the RFIC 320 and transfer the amplified signal to the second antenna 342. The second antenna 342 may transmit the transmission signal output from the second port (TX1 mid/high) of the RFIC 320 to the outside of the electronic device 101. The second power amplifier 3321 may receive power from the first power source circuitry 351 and amplify the transmission signal output from the second port (TX1 mid/high) of the RFIC 320.

In an embodiment, the third power amplifier 3331 may be connected to the RFIC 320, the third antenna 343, and the second power source circuitry 352.

In an embodiment, the fourth power amplifier 3341 may be connected to the first switch 335, the fourth antenna 344, and the fourth switch 3343.

In an embodiment, the fourth switch 3344 may be connected to the first power source circuitry 351 and the second power source circuitry 352, so that power is supplied to the first power amplifier 3311 and/or the fourth power amplifier 3341 under the control of the processor 310. The fourth switch 3343 may be connected to the first power source circuitry 351 and the second power source circuitry 352 so as to cause a second voltage (e.g., vcc#out1) and/or a third voltage (e.g., vec#out2) to be output.

In an embodiment, the third power amplifier 3331 may receive power from the second power source circuitry 352 and amplify the transmission signal output from the third port (TX2 mid/high) of the RFIC 320.

In an embodiment, the fourth power amplifier 3341 may receive power from the first power source circuitry 351 or second power source circuitry 352 connected via the fourth switch 3343 and amplify a transmission signal output from the fourth port (TX1 UHB) or the fifth port (TX2 UHB).

In an embodiment, when the first power source circuitry 351 or the second power source circuitry 352 is selected by the fourth switch 3343 under the control of the processor 310, the fourth switch 3343 may cause the second voltage (e.g., vcc#out1) and/or third voltage (e.g., vec#out2) to be output. The instructions stored in the memory 130 may cause, when executed by the processor 310, the electronic device 101 to, when the first power source circuitry 351 and/or the second power source circuitry 352 is selected by the fourth switch 3343, output the second voltage (e.g., vcc#out1) and/or third voltage (e.g., vcc#out2) using the fourth switch 3343.

When the electronic device 101 performs the EN-DC function, the second voltage (e.g., vcc#out1) and/or the third voltage (e.g., vec#out2) may be changed to an output voltage of the first power source circuitry 351 or second power source circuitry 352 according to a corresponding frequency band.

For example, descriptions will be provided in the following for a case in which, when the electronic device 101 performs the EN-DC function, the electronic device 101 simultaneously transmits the transmission signals of the first frequency band (LTE low) of the first communication network and the second frequency band or third frequency band (NR mid/high) of the second communication network. The electronic device 101 may transmit the transmission signal of the first frequency band (LTE low) of the first communication network via the first antenna 341. The transmission signal of the first frequency band (LTE low) of the first communication network may be transferred to the first power amplifier 3311 via the sixth port (TX2 low). The first power amplifier 3311 may receive power via the second power source circuitry 352 (e.g., the third voltage (e.g., vec#out2)). The electronic device 101 may transmit the transmission signal of the second frequency band or third frequency band (NR mid/high) of the second communication network via the second antenna 342. The transmission signal of the second frequency band or third frequency band (NR mid/high) of the second communication network may be transferred to the second power amplifier 3321 via the second port (TX1 mid/high). The second power amplifier 3321 may receive power via the first power source circuitry 351.

For example, descriptions will be provided in the following for a case in which, when the electronic device 101 performs the EN-DC function, the electronic device 101 simultaneously transmits the transmission signals of the first frequency band (LTE low) of the first communication network and the fourth frequency band (NR UHB) of the second communication network.

In an embodiment, the electronic device 101 may transmit the transmission signal of the first frequency band (LTE low) of the first communication network via the first antenna 341. The transmission signal of the first frequency band (LTE low) of the first communication network may be transferred to the first power amplifier 3311 via the sixth port (TX2 low). The first power amplifier 3311 may receive power via the second power source circuitry 352 (e.g., the third voltage (e.g., vcc#out2)). The electronic device 101 may transmit the transmission signal of the fourth frequency band (NR UHB) of the second communication network via the fourth antenna 344. The transmission signal of the fourth frequency band (NR UHB) of the second communication network may be transferred to the fourth power amplifier 3341 via the fourth port (TX1 UHB). The fourth power amplifier 3341 may receive power via the first power source circuitry 351 (e.g., the second voltage (e.g., vcc#out1)). Since the sixth port (TX2 low) is configured to be dedicated to the second power source circuitry 352, and the fourth port (TX1 UHB) is configured to be dedicated to the first power source circuitry 351, the electronic device 101 may control the fourth switch 3343 including a DPDT switch under the control of the processor 310 so that the first power source circuitry 351 (e.g., the second voltage (e.g., vcc#out1)) and the fourth power amplifier 3341 are connected, and that the second power source circuitry 352 (e.g., the third voltage (e.g., vec#out2)) and the first power amplifier 3311 are connected. The instructions stored in the memory 130 may cause, when executed by the processor 310, the electronic device 101 to perform control so that the first power source circuitry 351 (e.g., the second voltage (e.g., vcc#out1)) and the fourth power amplifier 3341 are connected, and to control the fourth switch 3343 including the DPDT switch so that the second power source circuitry 352 (e.g., the third voltage (e.g., vcc#out2)) and the first power amplifier 3311 are connected. The fourth power amplifier 3341 may amplify, based on the power supplied from the first power source circuitry 351, the transmission signal output from the fourth port (TX1 UHB) and output the amplified signal to the fourth antenna 344.

For example, descriptions will be provided in the following for a case in which, when the electronic device 101 performs the EN-DC function, the electronic device 101 simultaneously transmits the transmission signals of the second frequency band (LTE mid) of the first communication network and the first frequency band (NR low) of the second communication network.

In an embodiment, the electronic device 101 may transmit the transmission signal of the second frequency band (LTE mid) of the first communication network via the second antenna 341. The transmission signal of the second frequency band (LTE mid) of the first communication network may be transferred to the second power amplifier 3321 via the second port (TX1 mid/high). The second power amplifier 3321 may receive power via the first power source circuitry 351. The electronic device 101 may transmit the transmission signal of the first frequency band (NR low) of the second communication network via the first antenna 341. The transmission signal of the first frequency band (NR low) of the second communication network may be transferred to the first power amplifier 3311 via the sixth port (TX2 low). The first power amplifier 3311 may receive power via the second power source circuitry 352.

For example, descriptions will be provided in the following for a case in which, when the electronic device 101 performs the EN-DC function, the electronic device 101 simultaneously transmits the transmission signals of the second frequency band (LTE mid) of the first communication network and the second frequency band/third frequency band (NR mid/high) of the second communication network.

In an embodiment, the electronic device 101 may transmit the transmission signal of the second frequency band (LTE mid) of the first communication network via the third antenna 343. The transmission signal of the second frequency band (LTE mid) of the first communication network may be transferred to the third power amplifier 3331 via the third port (TX2 mid/high). The third power amplifier 3331 may receive power via the second power source circuitry 352. The electronic device 101 may transmit the transmission signal of the second frequency band/third frequency band (NR mid/high) of the second communication network via the second antenna 342. The transmission signal of the second frequency band/third frequency band (NR mid/high) of the second communication network may be transferred to the second power amplifier 3321 via the second port (TX1 mid/high). The second power amplifier 3321 may receive power via the first power source circuitry 351.

For example, descriptions will be provided in the following for a case in which, when the electronic device 101 performs the EN-DC function, the electronic device 101 simultaneously transmits the transmission signals of the second frequency band (LTE mid) of the first communication network and the fourth frequency band (NR UHB) of the second communication network.

In an embodiment, the electronic device 101 may transmit the transmission signal of the second frequency band (LTE mid) of the first communication network via the second antenna 342. The transmission signal of the second frequency band (LTE mid) of the first communication network may be transferred to the second power amplifier 3321 via the second port (TX1 mid/high). The second power amplifier 3321 may receive power via the first power source circuitry 351. The electronic device 101 may transmit the transmission signal of the fourth frequency band (NR UHB) of the second communication network via the fourth antenna 344. The transmission signal of the fourth frequency band (NR UHB) of the second communication network may be transferred to the fourth power amplifier 3341 via the fifth port (TX2 UHB). The fourth power amplifier 3341 may receive power via the second power source circuitry 352 (e.g., the second voltage (e.g., vcc#out1)). Since the second port (TX1 mid/high) is configured to be dedicated to the first power source circuitry 351, and the fifth port (TX2 UHB) is configured to be dedicated to the second power source circuitry 352, the electronic device 101 may control the fourth switch 3343 including the DPDT switch under the control of the processor 310 so that the second power source circuitry 352 (e.g., the second voltage (e.g., vcc#out1)) and the fourth power amplifier 3341 are connected. Since the second port (TX1 mid/high) is configured to be dedicated to the first power source circuitry 351, and the fifth port (TX2 UHB) is configured to be dedicated to the second power source circuitry 352, the instructions stored in the memory 130 may cause, when executed by the processor 310, the electronic device 101 to control the fourth switch 3343 including the DPDT switch so that the second power source circuitry 352 (e.g., the second voltage (e.g., vcc#out1)) and the fourth power amplifier 3341 are connected. The electronic device 101 may control the first switch 335 so that, when the second power source circuitry 352 supplies power to the fourth power amplifier 3341, the transmission signal from the fifth port (TX2 UHB) is transferred to the fourth power amplifier 3341. The electronic device 101 may control the first switch 335 so that, when the second power source circuitry 352 supplies power to the fourth power amplifier 3341, the transmission signal from the fifth port (TX2 UHB) is transferred to the fourth power amplifier 3341.

For example, descriptions will be provided in the following for a case in which, when the electronic device 101 performs the EN-DC function, the electronic device 101 simultaneously transmits the transmission signals of the third frequency band (LTE high) of the first communication network and the first frequency band (NR low) of the second communication network.

In an embodiment, the electronic device 101 may transmit the transmission signal of the third frequency band (LTE high) of the first communication network via the second antenna 342. The transmission signal of the third frequency band (LTE high) of the first communication network may be transferred to the second power amplifier 3321 via the second port (TX1 mid/high). The second power amplifier 3321 may receive power via the first power source circuitry 351. The electronic device 101 may transmit the transmission signal of the first frequency band (NR low) of the second communication network via the first antenna 341. The transmission signal of the first frequency band (NR low) of the second communication network may be transferred to the first power amplifier 3311 via the sixth port (TX2 low). The first power amplifier 3311 may receive power via the second power source circuitry 352. Under the control of the processor 310, the electronic device 101 may control the fourth switch 3343 including the DPDT switch so that the second power source circuitry 352 (e.g., the third voltage (e.g., vcc#out2)) and the first power amplifier 3311 are connected. The instructions stored in the memory 130 may cause, when executed by the processor 310, the electronic device 101 to control the fourth switch 3343 including the DPDT switch so that the second power source circuitry 352 (e.g., the third voltage (e.g., vcc#out2)) and the first power amplifier 3311 are connected.

For example, descriptions will be provided in the following for a case in which, when the electronic device 101 performs the EN-DC function, the electronic device 101 simultaneously transmits the transmission signals of the third frequency band (LTE high) of the first communication network and the second frequency band (NR mid) of the second communication network.

In an embodiment, the electronic device 101 may transmit the transmission signal of the third frequency band (LTE high) of the first communication network via the third antenna 343. The transmission signal of the third frequency band (LTE high) of the first communication network may be transferred to the third power amplifier 3331 via the third port (TX2 mid/high). The third power amplifier 3331 may receive power via the second power source circuitry 352. The electronic device 101 may transmit the transmission signal of the second frequency band (NR mid) of the second communication network via the second antenna 342. The transmission signal of the second frequency band (NR mid) of the second communication network may be transferred to the second power amplifier 3321 via the second port (TX1 mid/high). The second power amplifier 3321 may receive power via the first power source circuitry 351.

For example, descriptions will be provided in the following for a case in which, when the electronic device 101 performs the EN-DC function, the electronic device 101 simultaneously transmits the transmission signals of the third frequency band (LTE high) of the first communication network and the fourth frequency band (NR UHB) of the second communication network.

In an embodiment, the electronic device 101 may transmit the transmission signal of the third frequency band (LTE high) of the first communication network via the second antenna 342. The transmission signal of the third frequency band (LTE high) of the first communication network may be transferred to the second power amplifier 3321 via the second port (TX1 mid/high). The second power amplifier 3321 may receive power via the first power source circuitry 351. The electronic device 101 may transmit the transmission signal of the fourth frequency band (NR UHB) of the second communication network via the fourth antenna 344. The transmission signal of the fourth frequency band (NR UHB) of the second communication network may be transferred to the fourth power amplifier 3341 via the fifth port (TX2 UHB). The fourth power amplifier 3341 may receive power via the second power source circuitry 352. Since the second port (TX1 mid/high) is configured to be dedicated to the first power source circuitry 351, and the fifth port (TX2 UHB) is configured to be dedicated to the second power source circuitry 352, the electronic device 101 may control the fourth switch 3343 including the DPDT switch under the control of the processor 310 so that the second power source circuitry 352 (e.g., the second voltage (e.g., vcc#out1)) and the fourth power amplifier 3341 are connected. Since the second port (TX1 mid/high) is configured to be dedicated to the first power source circuitry 351, and the fifth port (TX2 UHB) is configured to be dedicated to the second power source circuitry 352, the instructions stored in the memory 130 may cause, when executed by the processor 310, the electronic device 101 to control the fourth switch 3343 including the DPDT switch so that the second power source circuitry 352 (e.g., the second voltage (e.g., vcc#out1)) and the fourth power amplifier 3341 are connected.

For example, descriptions will be provided in the following for a case in which, when the electronic device 101 performs the transmission hopping (TX hopping) function, the electronic device 101 simultaneously transmits the transmission signals of the second frequency band (LTE mid) of the first communication network and the second frequency band/third frequency band (NR mid/high) of the second communication network.

In an embodiment, when performing the EN-DC function, the electronic device 101 may transmit the transmission signal of the second frequency band (LTE mid) of the first communication network via the third antenna 343. In order to increase antenna efficiency in the same frequency band, the electronic device 101 may perform the TX hopping function.

In an embodiment, when performing the TX hopping function, the electronic device 101 may transmit the transmission signal of the second frequency band (LTE mid) of the first communication network via the second antenna 342.

When an antenna is changed from the third antenna 343 to the second antenna 342, the transmission signal of the second frequency band (LTE mid) of the first communication network may be transferred to the second power amplifier 3321 via the second port (TX1 mid/high). The second power amplifier 3321 may receive power via the first power source circuitry 351.

When the electronic device 101 transmits the transmission signal of the second frequency band (LTE mid) of the first communication network via the second antenna 342, the electronic device 101 may transmit the transmission signal of the second frequency band/third frequency band (NR mid/high) of the second communication network using the third antenna 343 instead of the second antenna 342. The transmission signal of the second frequency band/third frequency band (NR mid/high) of the second communication network may be transferred to the third power amplifier 3331 via the third port (TX2 mid/high). The third power amplifier 3331 may receive power via the second power source circuitry 352.

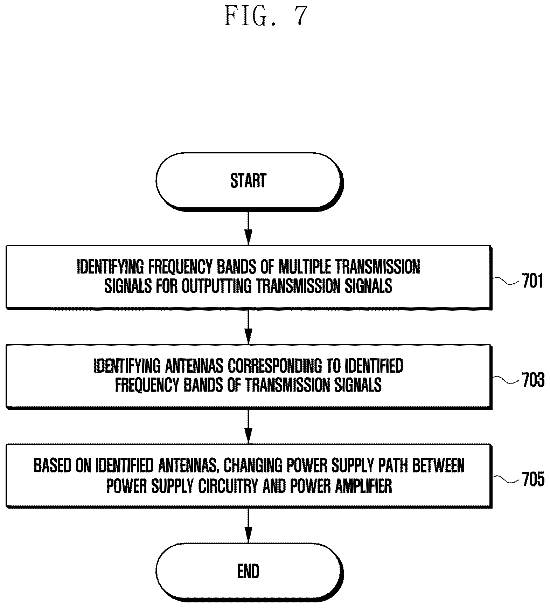

FIG. 7 is a flowchart illustrating an example communication circuitry control operation of the electronic device 101 according to various embodiments.

In an embodiment, the instructions stored in the memory 130 may cause, when executed by the processor 310, the electronic device 101 to perform a communication circuitry control operation.

In an embodiment, in operation 701, under the control of the processor 310, the electronic device 101 may identify frequency bands of multiple transmission signals in order to output the transmission signals. The outputting of the multiple transmission signals by the electronic device 101 may correspond to performing an EN-DC function or a TX hopping function.

In an embodiment, in operation 701, the instructions stored in the memory 130 may cause, when executed by the processor 310, the electronic device 101 to identify frequency bands of multiple transmission signals in order to output the transmission signals.

In an embodiment, in operation 703, under the control of the processor 310, the electronic device 101 may identify an antenna (e.g., the first antenna 341, the second antenna 342, the third antenna 343, or the fourth antenna 344) corresponding to an identified frequency band.

In an embodiment, in operation 703, the instructions stored in the memory 130 may cause, when executed by the processor 310, the electronic device 101 to identify an antenna (e.g., the first antenna 341, the second antenna 342, the third antenna 343, or the fourth antenna 344) corresponding to an identified frequency band.

In an embodiment, in operation 705, under the control of the processor 310, the electronic device 101 may, based on the identified antenna (e.g., the first antenna 341, the second antenna 342, the third antenna 343, or the fourth antenna 344), change a power supply path between the power supply circuitry 350 (e.g., the first power source circuitry 351 or the second power source circuitry 352) and a power amplifier (e.g., the first power amplifier 3311, the second power amplifier 3321, the third power amplifier 3331, or the fourth power amplifier 3341).

In an embodiment, in operation 705, the instructions stored in the memory 130 may cause, when executed by the processor 310, the electronic device 101 to, based on the identified antenna (e.g., the first antenna 341, the second antenna 342, the third antenna 343, or the fourth antenna 344), change a power supply path between the power supply circuitry 350 (e.g., the first power source circuitry 351 or the second power source circuitry 352) and a power amplifier (e.g., the first power amplifier 3311, the second power amplifier 3321, the third power amplifier 3331, or the fourth power amplifier 3341).

In an embodiment, in operation 705, under the control of the processor 310, the electronic device 101 may, based on the identified antenna (e.g., the first antenna 341, the second antenna 342, the third antenna 343, or the fourth antenna 344), change a connection path between a port of the RFIC 320 and the power amplifier (e.g., the first power amplifier 3311, the second power amplifier 3321, the third power amplifier 3331, or the fourth power amplifier 3341).

In an embodiment, in operation 705, the instructions stored in the memory 130 may cause, when executed by the processor 310, the electronic device 101 to, based on the identified antenna (e.g., the first antenna 341, the second antenna 342, the third antenna 343, or the fourth antenna 344), change a connection path between a port of the RFIC 320 and the power amplifier (e.g., the first power amplifier 3311, the second power amplifier 3321, the third power amplifier 3331, or the fourth power amplifier 3341).

In an embodiment, in operation 705, under the control of the processor 310, the electronic device 101 may, based on the identified antenna (e.g., the first antenna 341, the second antenna 342, the third antenna 343, or the fourth antenna 344), change a connection path between a port of the RFIC 320 and a power amplifier (e.g., the first power amplifier 3311, the second power amplifier 3321, the third power amplifier 3331, or the fourth power amplifier 3341), and change a power supply path between the power supply circuitry 350 and the power amplifier (e.g., the first power amplifier 3311, the second power amplifier 3321, the third power amplifier 3331, or the fourth power amplifier 3341).

In an embodiment, in operation 705, the instructions stored in the memory 130 may cause, when executed by the processor 310, the electronic device 101 to, based on the identified antenna (e.g., the first antenna 341, the second antenna 342, the third antenna 343, or the fourth antenna 344), change a connection path between a port of the RFIC 320 and a power amplifier (e.g., the first power amplifier 3311, the second power amplifier 3321, the third power amplifier 3331, or the fourth power amplifier 3341), and change a power supply path between the power supply circuitry 350 and the power amplifier (e.g., the first power amplifier 3311, the second power amplifier 3321, the third power amplifier 3331, or the fourth power amplifier 3341).

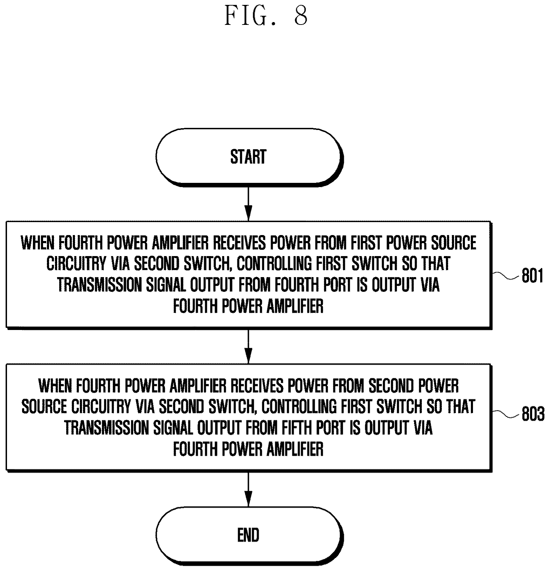

FIG. 8 is a flowchart illustrating an example communication circuitry control operation of the electronic device 101 according to various embodiments.

Referring to FIG. 4, FIG. 5, FIG. 6, and/or FIG. 8, in an embodiment, the instructions stored in the memory 130 may cause, when executed by the processor 310, the electronic device 101 to perform a communication circuitry control operation.

In an embodiment, in operation 801, when the fourth power amplifier 3341 receives power from the first power source circuitry 351 via the second switch 3342, the instructions may cause, when executed by the processor 310, the electronic device 101 to control the first switch 335 so that a transmission signal output from the fourth port (TX1 UHB) is output via the fourth power amplifier 3341.

In an embodiment, in operation 803, when the fourth power amplifier 3341 receives power from the second power source circuitry 352 via the second switch 3342, the instructions may cause, when executed by the processor 310, the electronic device 101 to control the first switch 335 so that a transmission signal output from the fifth port (TX2 UHB) is output via the fourth power amplifier 3341.

Referring to FIG. 3, FIG. 4, FIG. 5, FIG. 6, FIG. 7, and/or FIG. 8, the electronic device 101 of the disclosure may include the radio frequency integrated circuit (RFIC) 320 configured to output multiple radio frequency signals of a first communication network (e.g., a 4G communication network, a legacy communication network, or an LTE communication network) or a second communication network (e.g., a 5G communication network, or a new radio (NR) communication network).

In an embodiment, the electronic device 101 of the disclosure may include the power supply circuitry 350 including the first power source circuitry 351 and the second power source circuitry 352.

In an example embodiment, the electronic device of the disclosure may include: multiple power amplifiers including the first power amplifier configured to amplify a radio frequency signal of a first port (e.g., TX1 low) of a radio frequency integrated circuit (RFIC) and cause a transmission signal to be output via the first antenna, the second power amplifier 321 connected to the second antenna and configured to amplify a radio frequency signal of a second port (e.g., TX1 mid/high) of the RFIC and cause a transmission signal to be output via the second antenna, the third power amplifier configured to amplify a radio frequency signal of a third port (e.g., TX2 mid/high) of the RFIC and cause a transmission signal to be output via the third antenna, and the fourth power amplifier configured to amplify a radio frequency signal of a fourth port (e.g., TX1 UHB) of the RFIC or a radio frequency signal of a fifth port (e.g., TX2 UHB) of the RFIC and cause a transmission signal to be output via the fourth antenna.

In an example embodiment, the electronic device of the disclosure may include radio frequency front end (RFFE) circuitry including switches configured to connect the multiple power amplifiers and the power supply circuitry.

In an example embodiment, the electronic device of the disclosure may include a memory configured to store instructions, and at least one processor comprising processing circuitry.

In an example embodiment, the electronic device of the disclosure may include: the first switch configured to transfer the radio frequency signal of the fourth port (e.g., TX1 UHB) or the radio frequency signal the fifth port (e.g., TX2 UHB) to the fourth power amplifier under the control of at least one processor; and the second switch connected to the first power source circuitry or the second power source circuitry, and configured to supply power to the fourth power amplifier and the third power amplifier under the control of at least one processor.

In an example embodiment, at least one processor, individually and/or collectively, may be configured to: based on the fourth power amplifier receiving power from the first power source circuitry via the second switch, control the first switch so that the transmission signal output from the fourth port (e.g., TX1 UHB) is output via the fourth power amplifier; and based on the fourth power amplifier receiving power from the second power source circuitry via the second switch, control the first switch so that the transmission signal output from the fifth port (e.g., TX2 UHB) is output via the fourth power amplifier.

In an example embodiment, the electronic device of the disclosure may include the third switch configured to cause the second port (e.g., TX1 mid/high) and the third port (e.g., TX2 mid/high) to be transferred to the second power amplifier or the third power amplifier under the control of at least one processor.

In an example embodiment, at least one processor, individually and/or collectively, may be configured to: based on the third power amplifier receiving power from the first power source circuitry via the second switch, control the third switch so that the transmission signal output from the second port (e.g., TX1 mid/high) is output via the third power amplifier; and based on the third power amplifier receiving power from the second power source circuitry via the second switch, control the third switch so that the transmission signal output from the third port (e.g., TX2 mid/high) is output via the third power amplifier.

In an example embodiment, the first power source circuitry of the disclosure may be dedicatedly connected to at least one of the multiple power amplifiers.

In an example embodiment, the second power source circuitry of the disclosure may be dedicatedly connected to at least one of the multiple power amplifiers.

In an example embodiment, at least one processor, individually and/or collectively, may be configured to: based on an EU-TRAN new radio-dual connectivity (EN-DC) combination, control power connections between the multiple power amplifiers and the first and second power source circuitries.

In an example embodiment, at least one processor, individually and/or collectively, is configured to: based on the EN-DC combination, control connections between the multiple power amplifiers and the multiple radio frequency signals.

In an example embodiment, at least one processor, individually and/or collectively, is configured to: based on the EN-DC combination, control the power connections between the multiple power amplifiers and the first and second power source circuitries, or control the connections between the multiple power amplifiers and the multiple radio frequency signals.

In an example embodiment, the signal output from the fourth port (e.g., TX1 UHB) or fifth port (e.g., TX2 UHB) of the disclosure may include a transmission signal of a fourth frequency band (e.g., NR UHB) of the second communication network.

In an example embodiment, the signal output from the first port (e.g., TX1 low) of the disclosure may include a transmission signal of a first frequency band (e.g., LTE low) of the first communication network and a transmission signal of a first frequency band (e.g., NR low) of the second communication network.

In an example embodiment, the signal output from the second port (e.g., TX1 mid/high) of the disclosure may include a transmission signal of a second frequency band (e.g., LTE mid) of the first communication network and a transmission signal of a second frequency band (e.g., NR mid) of the second communication network.

In an example embodiment, the signal output from the third port (e.g., TX2 mid/high) of the disclosure may include a transmission signal of a third frequency band (e.g., LTE high) of the first communication network and a transmission signal of a third frequency band (e.g., NR high) of the second communication network.

In an example embodiment, the second switch may be included in the RFFE.

In an example embodiment, the second switch may be disposed outside the RFFE.

In an example embodiment, the first power source circuitry may be connected to the first power amplifier and the second switch.

In an example embodiment, the second power source circuitry may be connected to the second power amplifier and the second switch.

In an example embodiment, the first power amplifier may be configured to amplify the radio frequency signal output from the first port (e.g., TX1 low) or a radio frequency signal output from a sixth port (e.g., TX2 low) of the RFIC, and cause an output of the transmission signal of the first port or that of the sixth port via the first antenna.

In an example embodiment, the second power amplifier may be configured to amplify the radio frequency signal output from the second port (e.g., TX1 mid/high) and cause the transmission signal to be output via the second antenna.

In an example embodiment, the third power amplifier may be configured to amplify the radio frequency signal output from the third port (e.g., TX2 mid/high) and cause the transmission signal to be output via the third antenna.

In an example embodiment, the fourth power amplifier may be configured to amplify the radio frequency signal of the fourth port (e.g., TX1 UHB) or the fifth port (e.g.., TX2 UHB), and cause the transmission signal to be output via the fourth antenna.

In an example embodiment, the electronic device may include: a fourth switch connected to the first power source circuitry or the second power source circuitry and configured to supply power to the fourth power amplifier or the first power amplifier under the control of at least one processor; a the fifth switch configured to cause the radio frequency signal of the first port (e.g., TX1 low) or the sixth port (e.g., TX2 low) to be transferred to the first power amplifier under the control of at least one processor.

In an example embodiment, the fourth switch may be included in the RFFE.

In an example embodiment, the fourth switch may be disposed outside the RFFE.

In an example embodiment, the first power source circuitry may be connected to the second power amplifier and the fourth switch.

In an example embodiment, the second power source circuitry may be connected to the third power amplifier and the fourth switch.

In an example embodiment, the fourth switch may include a double pole double throw (DPDT) switch.

The electronic device according to various embodiments set forth herein may be one of various types of electronic devices. The electronic device may include, for example, a portable communication device (e.g., a smart phone), a computer device, a portable multimedia device, a portable medical device, a camera, a wearable device, a home appliance, or the like. The electronic device according to embodiments of the disclosure is not limited to those described above.

It should be appreciated that the various embodiments and the terms used therein are not intended to limit the technological features set forth herein to particular embodiments and the disclosure includes various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one or all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). If an element (e.g., a first element) is referred to, with or without the term "operatively" or "communicatively", as "coupled with/to" or "connected with/to" another element (e.g., a second element), the element may be coupled/connected with/to the other element directly (e.g., wiredly), wirelessly, or via a third element.

As used in various embodiments of the disclosure, the term "module" may include a unit implemented in hardware, software, or firmware, or any combination thereof, and may be interchangeably used with other terms, for example, "logic," "logic block," "component," or "circuit". The "module" may be a single integrated component, or a minimum unit or part thereof, adapted to perform one or more functions. For example, according to an embodiment, the "module" may be implemented in the form of an application-specific integrated circuit (ASIC).

Various embodiments as set forth herein may be implemented as software (e.g., the program 140) including one or more instructions that are stored in a storage medium (e.g., the internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions each may include a code generated by a compiler or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, methods according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play Store ^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities may be separately disposed in any other element. According to various embodiments, one or more of the above-described elements or operations may be omitted, or one or more other elements or operations may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration. According to various embodiments, operations performed by the module, the program, or another element may be carried out sequentially, in parallel, repeatedly, or heuristically, or one or more of the operations may be executed in a different order or omitted, or one or more other operations may be added.

While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be use in conjunction with any other embodiment(s) described herein.

## Claims

1. An electronic device comprising:
a radio frequency integrated circuit (RFIC) configured to output multiple radio frequency signals of a first communication network or a second communication network;
power supply circuitry comprising first power source circuitry and second power source circuitry;
multiple power amplifiers comprising a first power amplifier configured to amplify a radio frequency signal of a first port of the RFIC and cause a transmission signal to be output via a first antenna, a second power amplifier connected to a second antenna and configured to amplify a radio frequency signal of a second port of the RFIC and cause a transmission signal to be output via the second antenna, a third power amplifier configured to amplify a radio frequency signal of a third port of the RFIC and cause a transmission signal to be output via a third antenna, and a fourth power amplifier configured to amplify a radio frequency signal of a fourth port of the RFIC or a radio frequency signal of a fifth port of the RFIC and cause a transmission signal to be output via a fourth antenna;
radio frequency front end (RFFE) circuitry comprising switches configured to connect the multiple power amplifiers and the power supply circuitry;
at least one processor comprising processing circuitry;
a first switch configured to cause the radio frequency signal of the fourth port or the radio frequency signal of the fifth port to be transferred to the fourth power amplifier under control of at least one processor; and
a second switch connected to the first power source circuitry or the second power source circuitry and configured to supply power to the fourth power amplifier and the third power amplifier under control of at least one processor,
wherein at least one processor, individually and/or collectively, is configured to cause the electronic device to:
based on the fourth power amplifier receiving power from the first power source circuitry via the second switch, control the first switch so that the transmission signal output from the fourth port is output via the fourth power amplifier; and
based on the fourth power amplifier receiving power from the second power source circuitry via the second switch, control the first switch so that the transmission signal output from the fifth port is output via the fourth power amplifier.

2. The electronic device of claim 1, comprising a third switch configured to cause the second port and the third port to be transferred to the second power amplifier or the third power amplifier under control of at least one processor.

3. The electronic device of claim 2, wherein at least one processor, individually and/or collectively, is configured to cause the electronic device to:
based on the third power amplifier receiving power from the first power source circuitry via the second switch, control the third switch so that the transmission signal output from the second port is output via the third power amplifier; and
based on the third power amplifier receiving power from the second power source circuitry via the second switch, control the third switch so that the transmission signal output from the third port is output via the third power amplifier.

4. The electronic device of claim 1, wherein the first power source circuitry is dedicatedly connected to at least one of the multiple power amplifiers; and
wherein the second power source circuitry is dedicatedly connected to at least one of the multiple power amplifiers.

5. The electronic device of claim 4, wherein at least one processor, individually and/or collectively, is configured to cause the electronic device to:
based on an E-UTRAN new radio-dual connectivity (EN-DC) combination, control power connections between the multiple power amplifiers and the first and second power source circuitries.

6. The electronic device of claim 4, wherein at least one processor, individually and/or collectively, is configured to cause the electronic device to:
based on an E-UTRAN new radio-dual connectivity (EN-DC) combination, control connections between the multiple power amplifiers and the multiple radio frequency signals.

7. The electronic device of claim 4, wherein at least one processor, individually and/or collectively, is configured to cause the electronic device to:
based on an E-UTRAN new radio-dual connectivity (EN-DC) combination, control power connections between the multiple power amplifiers and the first and second power source circuitries, or control connections between the multiple power amplifiers and the multiple radio frequency signals.

8. The electronic device of claim 1, wherein the signal output from the fourth port or the fifth port comprises a transmission signal of a fourth frequency band of the second communication network.

9. The electronic device of claim 1, wherein the signal output from the first port comprises a transmission signal of a first frequency band of the first communication network and a transmission signal of a first frequency band of the second communication network,
wherein the signal output from the second port comprises a transmission signal of a second frequency band of the first communication network and a transmission signal of a second frequency band of the second communication network, and
wherein the signal output from the third port comprises a transmission signal of a third frequency band of the first communication network and a transmission signal of a third frequency band of the second communication network.

10. The electronic device of claim 1, wherein the second switch is included in the RFFE.

11. The electronic device of claim 1, wherein the second switch is disposed outside the RFFE.

12. The electronic device of claim 1, wherein the first power source circuitry is connected to the first power amplifier and the second switch.

13. The electronic device of claim 1, wherein the second power source circuitry is connected to the second power amplifier and the second switch.

14. The electronic device of claim 1, wherein the first power amplifier is configured to amplify the radio frequency signal output from the first port or a radio frequency signal output from a sixth port of the RFIC, and cause an output of the transmission signal of the first port or that of the sixth port via the first antenna,
wherein the second power amplifier is configured to amplify the radio frequency signal output from the second port and cause the transmission signal to be output via the second antenna,
wherein the third power amplifier is configured to amplify the radio frequency signal output from the third port and cause the transmission signal to be output via the third antenna, and
wherein the fourth power amplifier is configured to amplify the radio frequency signal of the fourth port or the fifth port, and cause the transmission signal to be output via the fourth antenna.

15. The electronic device of claim 14, comprising:
a fourth switch connected to the first power source circuitry or the second power source circuitry and configured to supply power to the fourth power amplifier or the first power amplifier under control of at least one processor; and
a fifth switch configured to cause the radio frequency signal of the first port or the sixth port to be transferred to the first power amplifier under control of at least one processor.
